(19) Europäisches Patentamt
European Patent Office
Office européen des brevets

(11) **EP 4 484 982 B1**

(12) # EUROPEAN PATENT SPECIFICATION

(45) Date of publication and mention
of the grant of the patent:
**08.04.2026 Bulletin 2026/15**

(21) Application number: **23807933.9**

(22) Date of filing: **18.05.2023**

(51) International Patent Classification (IPC):
*G01R 31/392* (2019.01)     *G01R 31/36* (2020.01)
*G01R 31/388* (2019.01)     *G01R 31/3835* (2019.01)
*G01R 31/396* (2019.01)     *G01R 19/165* (2006.01)
*G01R 19/00* (2006.01)     *G01R 19/10* (2006.01)
*H01M 10/052* (2010.01)

(52) Cooperative Patent Classification (CPC):
**B60L 58/10; G01R 19/16542; G01R 31/3835;
G01R 31/392; G01R 31/396; H01M 10/425;
H01M 10/482;** H01M 2010/4271; Y02E 60/10

(86) International application number:
**PCT/KR2023/006797**

(87) International publication number:
**WO 2023/224414 (23.11.2023 Gazette 2023/47)**

(54) **BATTERY DIAGNOSING APPARATUS, BATTERY DIAGNOSING METHOD, BATTERY PACK AND ELECTRIC VEHICLE**

BATTERIEDIAGNOSEVORRICHTUNG, BATTERIEDIAGNOSEVERFAHREN, BATTERIEPACK UND FAHRZEUG

APPAREIL DE DIAGNOSTIC DE BATTERIE, PROCÉDÉ DE DIAGNOSTIC DE BATTERIE, BLOC-BATTERIE ET VÉHICULE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **18.05.2022 KR 20220061076**

(43) Date of publication of application:
**01.01.2025 Bulletin 2025/01**

(60) Divisional application:
**26162362.3**

(73) Proprietor: **LG Energy Solution, Ltd.
Seoul 07335 (KR)**

(72) Inventors:
• SUNG, Yong-Chul
  Daejeon 34122 (KR)
• AN, Yang-Soo
  Daejeon 34122 (KR)

(74) Representative: **Plasseraud IP
104 Rue de Richelieu
CS92104
75080 Paris Cedex 02 (FR)**

(56) References cited:
CN-A- 112 208 389     CN-A- 113 219 361
CN-A- 113 391 214     CN-A- 114 441 979
JP-A- 2007 085 916     JP-A- 2014 134 467
JP-A- 2019 039 825     JP-A- 2020 119 712
KR-A- 20120 096 615     KR-A- 20220 015 790
US-A1- 2014 172 190

EP 4 484 982 B1

**Description**

TECHNICAL FIELD

The present disclosure relates to a technology for diagnosing a voltage abnormality of a battery.
The present application claims the benefit of Korean Patent Application No. 10-2022-0061076 filed on May 18, 2022 with the Korean Intellectual Property Office.

BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be recharged repeatedly.
Currently, commercially available batteries include nickel-cadmium batteries, nickel-hydrogen batteries, nickel-zinc batteries, lithium ion batteries and the like, and among them, lithium batteries have little or no memory effect, and thus they are gaining more attention than nickel-based batteries for their advantages that recharging can be done whenever it is convenient, the self-discharge rate is very low and the energy density is high.
Recently, as applications requiring high voltage (e.g., energy storage systems, electric vehicles) become widespread, the need for diagnostic technology that accurately detects voltage abnormalities in each of the plurality of battery cells connected in series within a battery pack is increasing.
The voltage abnormality of a battery cell refers to a fault condition in which the cell voltage drops and/or rises abnormally due to internal short-circuit, external short-circuit, failure of the voltage sensing line, or poor connection with the charging/discharging line.
Conventionally, there has been an attempt to diagnose the voltage abnormality of each battery cell by comparing the cell voltage, which is a voltage across both ends of each battery cell at a specific time point, with the average cell voltage of a plurality of battery cells at the same time point as the specific time point. However, since the cell voltage of each battery cell depends on the temperature, current, and/or SOH (State Of Health) of the corresponding battery cell, it is difficult to accurately diagnose the voltage abnormality of each battery cell just by simply comparing the cell voltages measured for a plurality of battery cells at a specific time point. For example, even in a battery cell without voltage abnormality, if the temperature deviation or SOH deviation from the remaining battery cells is large, the difference between the cell voltage of the battery cell and the average cell voltage may also be large.
To solve this problem, when diagnosing the voltage abnormality of each battery cell, it may be assumed to utilize additional parameters such as charging/discharging current, temperature of each battery cell, and/or SOC (State Of Charge) of each battery cell, together with the cell voltage of each battery cell. However, since the diagnosing method using additional parameters must be accompanied by a parameter detection process and a parameter comparison process, there are limitations in that the diagnosing method is relatively complex and requires a long time compared to the diagnosing method using the cell voltage as a single parameter. Document JP2007085916A discloses a battery diagnosing approach for a cell group including a plurality of battery cells.

DISCLOSURE

Technical Problem

The present disclosure is designed to solve the problems of the related art, and therefore the present disclosure is directed to providing a battery diagnosing apparatus, a battery diagnosing method, a battery pack, and a vehicle, which may determine a movement average of a cell voltage of each of the plurality of battery cells for each of at least one moving window with a given time length at every unit time, and efficiently and accurately diagnose an voltage abnormality of each battery cell based on the movement average of each battery cell.
These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosing apparatus for a cell group, which includes a plurality of battery cells connected in series and is mounted in an electric vehicle, the battery diagnosing apparatus comprising: a voltage sensing circuit configured to periodically generate a voltage signal representing a cell voltage of each battery cell while the electric vehicle is operating; and a control circuit configured to accumulatively store the cell voltage determined from the voltage signal in a memory unit and generate time series data representing the change over time in the cell voltage of each battery cell by using the accumulated cell voltage of each battery cell.

Preferably, the control circuit may be configured to (i) determine a first average cell voltage and a second average cell voltage of each battery cell based on the time series data [where the first average cell voltage is a short-term movement average, and the second average cell voltage is a long-term movement average], and (ii) detect a voltage abnormality of each battery cell based on the difference between the first average cell voltage and the second average cell voltage.

In an embodiment, for each battery cell, the control circuit may be configured to determine a short- and long-term average difference corresponding to the difference between the first average cell voltage and the second average cell voltage, for each battery cell, the control circuit may be configured to determine a cell diagnosis deviation corresponding to a deviation between the short- and long-term average difference of the battery cell and an average value of short- and long-term average differences of all battery cells, and the control circuit may be configured to detect a battery cell satisfying a condition that the cell diagnosis deviation exceeds a diagnosis threshold as a voltage abnormal cell.

Preferably, for each battery cell, the control circuit may be configured to generate time series data of the cell diagnosis deviation and detect a voltage abnormality of the battery cell from the time at which the cell diagnosis deviation exceeds the diagnosis threshold or the number of data of the cell diagnosis deviation exceeding the diagnosis threshold.

In another embodiment, for each battery cell, the control circuit may be configured to determine a short- and long-term average difference corresponding to the difference between the first average cell voltage and the second average cell voltage, for each battery cell, the control circuit may be configured to determine a cell diagnosis deviation by calculating a deviation between the short- and long-term average difference of the battery cell and an average value of short- and long-term average differences of all battery cells, the control circuit may be configured to determine a statistical variable threshold that depends on a standard deviation of the cell diagnosis deviations of all battery cells, the control circuit may be configured to generate time series data of a filter diagnosis value by filtering the time series data on the cell diagnosis deviation of each battery cell based on the statistical variable threshold, and the control circuit may be configured to detect a voltage abnormality of the battery cell from the time at which the filter diagnosis value exceeds a diagnosis threshold or the number of data of the filter diagnosis value that exceeds the diagnosis threshold.

In still another embodiment, for each battery cell, the control circuit may be configured to determine a short- and long-term average difference corresponding to the difference between the first average cell voltage and the second average cell voltage, for each battery cell, the control circuit may be configured to determine a normalized value of the short- and long-term average difference as a normalized cell diagnosis deviation and determine a statistical variable threshold that depends on a standard deviation for the normalized cell diagnosis deviations of all battery cells, the control circuit may be configured to generate time series data of the filter diagnosis value by filtering the time series data on the normalized cell diagnosis deviation of each battery cell based on the statistical variable threshold, and the control circuit may be configured to detect a voltage abnormality of the battery cell from the time at which the filter diagnosis value exceeds a diagnosis threshold or the number of data of the filter diagnosis value that exceeds the diagnosis threshold.

Preferably, the control circuit may be configured to normalize the short- and long-term average difference for each battery cell by dividing the short- and long-term average difference by an average value of short- and long-term average differences of all battery cells.

Alternatively, the control circuit may be configured to normalize the short- and long-term average difference for each battery cell by calculating the logarithm of the short- and long-term average difference.

In still another embodiment, the control circuit may be configured to generate time series data representing the change over time in the cell voltage of each battery cell using a voltage difference between an average value of the cell voltages of all battery cells and the cell voltage of each battery cell measured per unit time.

In still another embodiment, for each battery cell, the control circuit may be configured to determine a short- and long-term average difference corresponding to the difference between the first average cell voltage and the second average cell voltage, for each battery cell, the control circuit may be configured to determine a normalized value of the short- and long-term average difference as a normalized cell diagnosis deviation and generate time series data of the normalized cell diagnosis deviation for each battery cell, the control circuit may be configured to generate time series data of the normalized cell diagnosis deviation for each battery cell by recursively repeating the following steps (i) to (iv) at least once:

(i) determining a first movement average and a second movement average for the time series data of the normalized cell diagnosis deviation of each battery cell [where the first movement average is a short-term movement average, and the second movement average is a long-term movement average], (ii) for each battery cell, determining a short- and long-term average difference corresponding to the difference between the first movement average and the second movement average, (iii) for each battery cell, determining a normalized value of the short- and long-term average difference as a normalized cell diagnosis deviation, and (iv) generating time series data of the normalized cell diagnosis deviation for each battery cell,
the control circuit may be configured to determine a statistical variable threshold that depends on a standard deviation of normalized cell diagnosis deviations of all battery cells, the control circuit may be configured to generate time series data of the filter diagnosis value by filtering the time series data on the cell diagnosis deviation of each battery cell based on the statistical variable threshold, and the control circuit may be configured to detect a voltage abnormality of the battery cell from the time at which the filter diagnosis value exceeds a diagnosis threshold or the number of data of the filter diagnosis value that exceeds the diagnosis threshold.

In the battery diagnosing apparatus according to the present disclosure, a profile for the time series data of the cell voltage of each battery cell may include voltage data equal to or less than a preset diagnosis start voltage and include an inflection point after a time point at which the voltage data is measured.

In another aspect of the present disclosure, there is also provided a battery diagnosing method for a cell group, which includes a plurality of battery cells connected in series and is mounted in an electric vehicle, the battery diagnosing method comprising: (a) generating a voltage signal representing a cell voltage of each battery cell while the electric vehicle is operating; (b) accumulatively storing the cell voltage determined from the voltage signal in a memory unit; (c) periodically generating time series data representing the change over time in the cell voltage of each battery cell; (d) determining a first average cell voltage and a second average cell voltage of each battery cell based on the time series data [where the first average cell voltage is a short-term movement average, and the second average cell voltage is a long-term movement average]; and (e) detecting a voltage abnormality of each battery cell based on the difference between the first average cell voltage and the second average cell voltage.

In an embodiment, the step (e) may include (e1) for each battery cell, determining a short- and long-term average difference corresponding to the difference between the first average cell voltage and the second average cell voltage; (e2) for each battery cell, determining a cell diagnosis deviation corresponding to a deviation between the short- and long-term average difference of the battery cell and an average value of short- and long-term average differences of all battery cells; and (e3) detecting a battery cell satisfying a condition that the cell diagnosis deviation exceeds a diagnosis threshold as a voltage abnormal cell.

Preferably, the step (e) may include (e1) for each battery cell, generating time series data of the cell diagnosis deviation; and (e2) detecting a voltage abnormality of the battery cell from the time at which the cell diagnosis deviation exceeds the diagnosis threshold or the number of data of the cell diagnosis deviation exceeding the diagnosis threshold.

In another embodiment, the step (e) may include (e1) for each battery cell, determining a short- and long-term average difference corresponding to the difference between the first average cell voltage and the second average cell voltage; (e2) for each battery cell, determining a cell diagnosis deviation by calculating a deviation between the short- and long-term average difference of the battery cell and an average value of short- and long-term average differences of all battery cells; (e3) determining a statistical variable threshold that depends on a standard deviation of the cell diagnosis deviations of all battery cells; (e4) generating time series data of a filter diagnosis value for each battery cell by filtering the time series data on the cell diagnosis deviation of each battery cell based on the statistical variable threshold; and (e5) detecting a voltage abnormality of the battery cell from the time at which the filter diagnosis value exceeds a diagnosis threshold or the number of data of the filter diagnosis value that exceeds the diagnosis threshold.

In still another embodiment, the (e) step may include (e1) for each battery cell, determining a short- and long-term average difference corresponding to the difference between the first average cell voltage and the second average cell voltage; (e2) for each battery cell, determining a normalized value of the short- and long-term average difference as a normalized cell diagnosis deviation; (e3) determining a statistical variable threshold that depends on a standard deviation for the normalized cell diagnosis deviations of all battery cells; (e4) generating time series data of the filter diagnosis value by filtering the time series data on the normalized cell diagnosis deviation of each battery cell based on the statistical variable threshold; and (e5) detecting a voltage abnormality of the battery cell from the time at which the filter diagnosis value exceeds a diagnosis threshold or the number of data of the filter diagnosis value that exceeds the diagnosis threshold.

Preferably, the step (e2) may be a step of normalizing the short- and long-term average difference for each battery cell by dividing the short- and long-term average difference by an average value of short- and long-term average differences of all battery cells.

Alternatively, the step (e2) may be a step of normalizing the short- and long-term average difference for each battery cell by calculating the logarithm of the short- and long-term average difference.

In still another embodiment, the step (a) may be a step of generating time series data representing the change over time in the cell voltage of each battery cell using a voltage difference between an average value of the cell voltages of all battery cells and the cell voltage of each battery cell measured per unit time.

In still another embodiment, the step (e) may include (e1) for each battery cell, determining a short- and long-term average difference corresponding to the difference between the first average cell voltage and the second average cell voltage; (e2) for each battery cell, determining a normalized value of the short- and long-term average difference as a normalized cell diagnosis deviation; (e3) generating time series data of the normalized cell diagnosis deviation for each battery cell; (e4) generating time series data of the normalized cell diagnosis deviation for each battery cell by recursively repeating the following steps (i) to (iv) at least once:

(i) determining a first movement average and a second movement average for the time series data of the normalized cell diagnosis deviation of each battery cell [where the first movement average is a short-term movement average, and the second movement average is a long-term movement average], (ii) for each battery cell, determining a short- and long-term average difference corresponding to the difference between the first movement average and the second movement average, (iii) for each battery cell, determining a normalized value of the short- and long-term average difference as a normalized cell diagnosis deviation, and (iv) generating time series data of the normalized cell diagnosis deviation for each battery cell,

(e5) determining a statistical variable threshold that depends on a standard deviation of normalized cell diagnosis deviations of all battery cells; (e6) generating time series data of the filter diagnosis value by filtering the time series data on the cell diagnosis deviation of each battery cell based on the statistical variable threshold; and (e7) detecting a voltage abnormality of the battery cell from the time at which the filter diagnosis value exceeds a diagnosis threshold or the number of data of the filter diagnosis value that exceeds the diagnosis threshold.

In the battery diagnosing method according to the present disclosure, a profile for the time series data of the cell voltage of each battery cell may include voltage data equal to or less than a preset diagnosis start voltage and include an inflection point after a time point at which the voltage data is measured.

In another aspect of the present disclosure, there is also provided a battery pack, comprising the battery diagnosing apparatus, and a vehicle, comprising the battery pack.

Advantageous Effects

According to an embodiment of the present disclosure, while the electric vehicle is operating, at every unit time, two movement averages of the cell voltage of each battery cell for two different time lengths may be determined, and the voltage abnormality of each battery cell may be diagnosed efficiently and accurately based on the difference between the two movement averages of each of the plurality of battery cells.

According to another embodiment of the present disclosure, the voltage abnormality of each battery cell may be accurately diagnosed by applying an advanced technique such as normalization and/or statistical variable threshold in analyzing the change trend difference between the two movement averages of each battery cell.

According to still another embodiment of the present disclosure, the time period in which the voltage abnormality of each battery cell has occurred and/or the voltage abnormality detection count may be precisely detected by analyzing the time series data of the filter diagnosis value determined based on the statistical variable threshold.

The effects of the present disclosure are not limited to the above-mentioned effects, and these and other effects not mentioned herein will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is an exemplary diagram showing an electric vehicle according to an embodiment of the present disclosure.
FIGS. 2a to 2h are graphs for illustrating the process of diagnosing a voltage abnormality of each battery cell from time series data showing the change over time in the cell voltage of each of the plurality of battery cells depicted in FIG. 1.
FIG. 3 is an exemplary flowchart showing a battery diagnosis method according to the first embodiment of the present disclosure.
FIG. 4 is an exemplary flowchart showing a battery diagnosis method according to the second embodiment of the present disclosure.
FIG. 5 is an exemplary flowchart showing a battery diagnosis method according to the third embodiment of the present disclosure.
FIG. 6 is an exemplary flowchart showing a battery diagnosis method according to the fourth embodiment of the present disclosure.
FIG. 7 is an exemplary flowchart showing a battery diagnosis method according to the fifth embodiment of the present disclosure.

BEST MODE

Hereinafter, the preferred embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are just a most preferred embodiment of the present disclosure, but not intended to fully describe the technical aspects of the present disclosure, so it should be understood that a variety of modifications could be made within the scope of the appended claims.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Additionally, the term "control unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

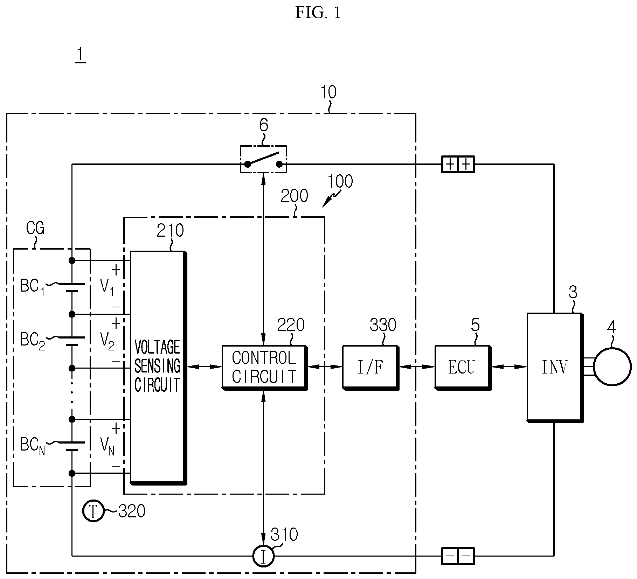

FIG. 1 is an exemplary diagram showing an electric vehicle according to an embodiment of the present disclosure.

Referring to FIG. 1, the electric vehicle 1 includes a battery pack 2, an inverter 3, an electric motor 4 and a vehicle controller 5.

The battery pack 2 includes a cell group CG, a switch 6, and a battery management system 100.

The cell group CG may be connected to the inverter 3 through a pair of power terminals provided to the battery pack 2. The cell group CG includes a plurality of battery cells $BC_1$ to $BC_N$ (N is a natural number of 2 or more) connected in series. The battery cell $BC_i$ is not particularly limited by its type as long as it is rechargeable, like a lithium-ion battery cell. i is an index for cell identification. i is a natural number from 1 to N.

The switch 6 is connected in series to the cell group CG. The switch 6 is installed in the current path for charging and discharging the cell group CG. The switch 6 is controlled to turn on and off in response to a switching signal from the battery management system 100. The switch 6 may be a mechanical relay that turns on and off by the magnetic force of the coil, or a semiconductor switch such as a MOSFET (Metal Oxide Semiconductor Field Effect transistor).

The inverter 3 is provided to convert the direct current (DC) from the cell group CG to alternating current (AC) in response to a command from the battery management system 100. The electric motor 4 may be, for example, a 3-phase AC motor. The electric motor 4 operates using the AC from the inverter 3.

The battery management system 100 is provided to take charge of overall control related to charging and discharging of the cell group CG while the electric vehicle 1 is operating. Here, the operation of the electric vehicle 1 may include moving the electric vehicle 1, parking, or waiting for a sign.

The battery management system 100 includes a battery diagnosing apparatus 200. The battery management system 100 may further include at least one of a current sensor 310, a temperature sensor 320, and an interface unit 330.

The battery diagnosing apparatus 200 is provided to diagnose voltage abnormalities in each of the plurality of battery cells $BC_1$ to $BC_N$ while the electric vehicle 1 is operating. The battery diagnosing apparatus 200 includes a voltage sensing circuit 210 and a control circuit 220.

The voltage sensing circuit 210 is connected to the positive electrode and negative electrode of each of the plurality of battery cells $BC_1$ to $BC_N$ through a plurality of voltage sensing lines. The voltage sensing circuit 210 is configured to measure the cell voltage across both ends of each battery cell BC at regular time intervals while the electric vehicle 1 is operating and generate a voltage signal representing the measured cell voltage.

The current sensor 310 is connected in series to the cell group CG through a current path. The current sensor 310 is configured to detect the battery current flowing through the cell group CG at regular time intervals while the electric vehicle 1 is operating and generate a current signal representing the detected battery current.

The temperature sensor 320 is configured to detect the temperature of the cell group CG at regular time intervals while the electric vehicle 1 is operating and generate a temperature signal representing the detected temperature.

The control circuit 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The control circuit 220 may have a memory unit 221. The memory unit 221 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory unit 221 may store data and programs required for computation by the control circuit 220. The memory unit 221 may store data indicating the result of computation by the control circuit 220. In particular, the control circuit 220 may record at least one of several parameters calculated at each unit time, which will be described later, in the memory unit 221.

The control circuit 220 may be operably coupled to the voltage sensing circuit 210, the temperature sensor 320, the current sensor 310, the interface unit 330, and/or the switch 6. The control circuit 220 may collect sensing signals from the voltage sensing circuit 210, the current sensor 310, and the temperature sensor 320 at regular time intervals while the electric vehicle 1 is operating. The sensing signals refers to voltage signal, current signal, and/or temperature signal synchronously detected. The control circuit 220 may convert the voltage signal and/or current signal and/or temperature signal into digital data and accumulatively store them in the memory unit 221 to generate time series data regarding the voltage and/or current and/or temperature of the battery cell.

The interface unit 330 may include a communication circuit configured to support wired or wireless communication between the control circuit 220 and the vehicle controller 5 (for example, an Electronic Control Unit (ECU)). The wired communication may be, for example, controller area network (CAN) communication, and the wireless communication may be, for example, Zigbee or Bluetooth communication. The communication protocol is not limited to a particular type and may include any communication protocol capable of supporting wired/wireless communication between the control circuit 220 and the vehicle controller 5.

The interface unit 330 may be coupled with an output device (e.g., display, speaker) that provides information received from the vehicle controller 5 and/or the control circuit 220 in a form recognizable to the user. The vehicle controller 5 may control the inverter 3 based on battery information (e.g., voltage, current, temperature, SOC) collected through communication with the battery management system 100.

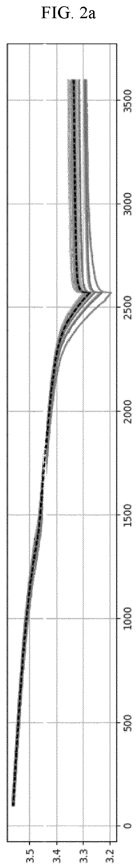

FIGS. 2a to 2h are graphs for illustrating the process of diagnosing a voltage abnormality of each battery cell from time series data showing the change over time in the cell voltage of each of the plurality of battery cells depicted in FIG. 1.

FIG. 2a shows a voltage curve of each of the plurality of battery cells $BC_1$ to $BC_N$. In this embodiment, the number of battery cells for which the voltage curve is illustrated is 14. However, the present disclosure is not limited by the amount of battery cells. The control circuit 220 collects the voltage signal from the voltage sensing circuit 210 at every unit time while the electric vehicle 1 is operating, and accumulatively records the voltage value of the cell voltage of each battery cell $BC_i$ in the memory unit 221. The unit time may be an integer multiple of the voltage measurement period of the voltage sensing circuit 210.

The control circuit 220 may generate cell voltage time series data representing the history of the cell voltage of each battery cell over time based on the voltage value of the cell voltage of each battery cell $BC_i$ recorded in the memory unit 221. Whenever the cell voltage is measured, the number of cell voltage time series data increases by 1.

The plurality of voltage curves shown in FIG. 2a are in one-to-one relationship with the plurality of battery cells $BC_1$ to $BC_N$. Therefore, each voltage curve represents the change history of the cell voltage of a battery cell $BC_i$ associated therewith.

The control circuit 220 may determine a movement average of a cell voltage for each of the plurality of battery cells $BC_1$ to $BC_N$ per unit time using one moving window or two moving windows. When using two moving windows, the time length for one moving window is different from the time length for the other moving window.

Here, the time length of each moving window is an integer multiple of unit time, the end point of each moving window is a current time point, and the starting point of each moving window is a time point that is ahead of the current time point by a given time length.

Hereinafter, for convenience of explanation, one of two moving windows associated with the shorter time length will be referred to as a first moving window, and the other associated with the longer time length will be referred to as a second moving window.

The control circuit 220 may diagnose a voltage abnormality of each battery cell $BC_i$ using only the first moving window or both the first moving window and the second moving window.

The control circuit 220 may compare a short-term change trend and a long-term change trend of the cell voltage of the $i^{th}$ battery cell $BC_i$ per unit time, based on the cell voltage of the $i^{th}$ battery cell $BC_i$ collected per unit time, while the electric vehicle 1 is operating.

The control circuit 220 may determine the first average cell voltage, which is the movement average for the cell voltage of the $i^{th}$ battery cell $BC_i$ by the first moving window, per unit time, using Equation 1 or 2 below.

Equation 1 is a movement average calculation formula using the arithmetic average method, and Equation 2 is a movement average calculation formula using the weighted average method.

<Equation 1>

$$SMA_i[k] = \frac{\sum_{j=1}^{S} V_i[k-S+j]}{S}$$

<Equation 2>

$$SMA_i[k] = \frac{SMA_i[k-1] \times (S-1)}{S} + \frac{V_i[k]}{S}$$

In Equations 1 and 2, k is a time index representing a current time point, $SMA_i[k]$ is the first average cell voltage of the $i^{th}$ battery cell $BC_i$ of the current time point, S is a value obtained by dividing the time length of the first moving window divided by unit time, and $V_i[k]$ is the cell voltage of the $i^{th}$ battery cell $BC_i$ at the current time point. For example, if the unit time is 1 second and the time length of the first moving window is 10 seconds, S is 10. When x is a natural number equal to or smaller than k, $V_i[k-x]$ and $SMA_i[k-x]$ represent the cell voltage and the first average cell voltage of the $i^{th}$ battery cell $BC_i$ when the time index is k-x, respectively. For reference, the control circuit 220 may be set to increase the time index by 1 at each unit time.

The control circuit 220 may determine the second average cell voltage, which is a movement average for the cell voltage of the $i^{th}$ battery cell $BC_i$ by the second moving window, per unit time, using Equation 3 or 4 below.

Equation 3 is a movement average calculation formula using the arithmetic average method, and Equation 4 is a movement average calculation formula using the weighted average method.

<Equation 3>

$$LMA_i[k] = \frac{\sum_{j=1}^{L} V_i[k-L+j]}{L}$$

<Equation 4>

$$LMA_i[k] = \frac{LMA_i[k-1] \times (L-1)}{L} + \frac{V_i[k]}{L}$$

In Equations 3 and 4, k is a time index representing a current time point, $LMA_i[k]$ is the second average cell voltage of the $i^{th}$ battery cell $BC_i$ at the current time point, L is a value obtained by dividing the time length of the second moving window by unit time, and $V_i[k]$ is the cell voltage of the $i^{th}$ battery cell $BC_i$ at the current time point. For example, if the unit time is 1 second and the time length of the second moving window is 100 seconds, L is 100. When x is a natural number equal to or smaller than k, $LMA_i[k-x]$ represents the second average cell voltage when the time index is k-x.

In one embodiment, as $V_i[k]$ of Equations 1 to 4, the control circuit 220 may input the difference between a criterion cell voltage of the cell group CG and the cell voltage of the battery cell $BC_i$ at the current time point, instead of the cell voltage of each battery cell $BC_i$ at the current time point.

The criterion cell voltage of the cell group CG at the current time point is an average value of a plurality of cell voltages at the current time point determined from the plurality of battery cells $BC_1$ to $BC_N$. In a modification, the average value of plurality of cell voltages may be replaced by a median value.

Specifically, the control circuit 220 may set $VD_i[k]$ of Equation 5 below as $V_i[k]$ of Equations 1 to 4.

<Equation 5>

$$VD_i[k] = V_{av}[k] - V_i[k]$$

In Equation 5, $V_{av}[k]$ is an average value of the plurality of cell voltages as the criterion cell voltage of the cell group CG at the current time point.

If the time length of the first moving window is shorter than the time length of the second moving window, the first average cell voltage may be called a 'short-term movement average' of the cell voltage, and the second average cell voltage may be called a 'long-term movement average' of the cell voltage.

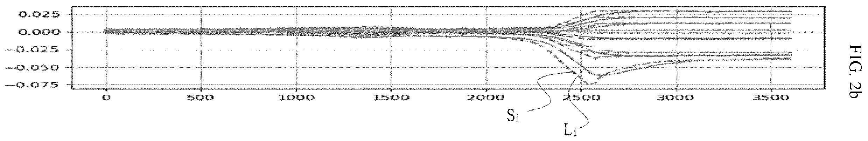

FIG. 2b shows a short-term movement average line and a long-term movement average line for the cell voltage of the $i^{th}$ battery cell $BC_i$ determined from the plurality of voltage curves shown in FIG. 2a. In FIG. 2b, the horizontal axis represents time, and the vertical axis represents the short-term movement average and the long-term movement average of the cell voltage.

Referring to FIG. 2b, the plurality of movement average lines $S_i$ shown in dotted lines is in one-to-one relationship with the plurality of battery cells $BC_1$ to $BC_N$, and represents the change history over time of the first average cell voltage $SMA_i[k]$ of each battery cell $BC_i$. In addition, the plurality of movement average lines $L_i$ shown in solid lines is in one-to-one relationship with the plurality of battery cells $BC_1$ to $BC_N$, and represents the change history over time in the second average cell voltage $LMA_i[k]$ of each battery cell $BC_i$.

The dotted line graph and the solid line graph are obtained using Equations 2 and 4, respectively. In addition, $VD_i[k]$ in Equation 5 is used as $V_i[k]$ in Equations 2 and 4, and $V_{av}[k]$ is set as the average of the plurality of cell voltages. The time length of the first moving window is 10 seconds, and the time length of the second moving window is 100 seconds.

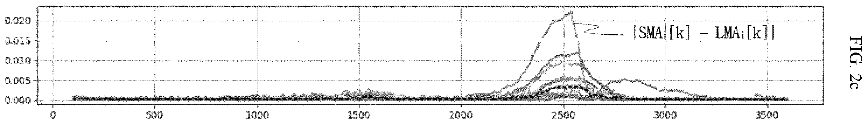

FIG. 2c shows the change over time in a short- and long-term average difference (absolute value) corresponding to the difference between the first average cell voltage $SMA_i[k]$ and the second average cell voltage $LMA_i[k]$ of each battery cell depicted in FIG. 2b. In FIG. 2c, the horizontal axis represents time, and the vertical axis represents the short- and long-term average difference of each battery cell $BC_i$.

The short- and long-term average difference of each battery cell $BC_i$ is the difference between the first average cell voltage $SMA_i$ and second average cell voltage $LMA_i$ of each battery cell $BC_i$ per unit time. As an example, the short- and long-term average difference of the $i^{th}$ battery cell $BC_i$ may be the same as a value obtained by subtracting one of $SMA_i[k]$ and $LMA_i[k]$ (e.g., the larger one) from the other (e.g., the smaller one).

The short- and long-term average difference of the $i^{th}$ battery cell $BC_i$ depends on the short-term change history and the long-term change history of the cell voltage of the $i^{th}$ battery cell $BC_i$.

The temperature or SOH of the $i^{th}$ battery cell $BC_i$ steadily affects the cell voltage of the $i^{th}$ battery cell $BC_i$ not only in the short term but also as in the long term. Therefore, if there is no voltage abnormality of the $i^{th}$ battery cell $BC_i$, the short- and long-term average difference of the $i^{th}$ battery cell $BC_i$ is not significantly different from the short- and long-term average difference of the remaining battery cells.

Meanwhile, voltage abnormality that suddenly occurs due to an internal short-circuit and/or an external short-circuit in the $i^{th}$ battery cell $BC_i$ has a greater influence on the first average cell voltage $SMA_i[k]$ than on the second average cell voltage $LMA_i[k]$. As a result, the short- and long-term average difference of the $i^{th}$ battery cell $BC_i$ has a large deviation from the short- and long-term average difference of the remaining battery cells without voltage abnormality.

The control circuit 220 may determine the short- and long-term average difference $|SMA_i[k]-LMA_i[k]|$ of each battery cell $BC_i$, per unit time, while the electric vehicle 1 is operating. In addition, the control circuit 220 may determine the average value of the short- and long-term average difference $|[SMA_i[k]-LMA_i[k]]|$. Hereinafter, the average value is expressed as $[SMA_i[k]-LMA_i[k]]_{av}$. The control circuit 220 may also determine a deviation of the short- and long-term average difference $|SMA_i[k]-LMA_i[k]|$ compared to the average value $|SMA_i[k]-LMA_i[k]|_{av}$ of the short- and long-term average difference as a cell diagnosis deviation $D_{diag,i}[k]$. In addition, the control circuit 220 may diagnose a voltage abnormality of each battery cell $BC_i$ based on the cell diagnosis deviation $D_{diag,i}[k]$.

In one embodiment, the control circuit 220 may diagnose that a voltage abnormality has occurred in the $i^{th}$ battery cell $BC_i$ when the cell diagnosis deviation $D_{diag,i}[k]$ for the $i^{th}$ battery cell $BC_i$ exceeds a preset diagnosis threshold (e.g., 0.015).

Preferably, the control circuit 220 may normalize the short- and long-term average difference $|SMA_i[k]-LMA_i[k]|$ of each battery cell $BC_i$ using a normalization criterion value to diagnose a voltage abnormality. Preferably, the normalization criterion value is the average value $|SMA_i[k]-LMA_i[k]|_{av}$ of the short- and long-term average difference.

Specifically, the control circuit 220 may set the average value $|[SMA_i[k]-LMA_i[k]]|_{av}$ of the short- and long-term average difference of the first to $N^{th}$ battery cells $BC_i$ to $BC_N$ as the normalization criterion value. The control circuit 220 may also normalize the short- and long-term average difference $|[SMA_i[k]-LMA_i[k]]|$ by dividing the short- and long-term average difference $|SMA_i[k]-LMA_i[k]|$ of each battery cell $BC_i$ by the normalization criterion value.

Equation 6 below represents the formula for normalizing the short- and long-term average difference $|SMA_i$

[k]-LMA$_i$[k]| of each battery cell BC$_i$. In this embodiment, the value calculated by Equation 6 may be called the normalized cell diagnosis deviation D$^*_{diag,i}$[k].

<Equation 6>

$$D^*_{diag,i}[k] = (|SMA_i[k]\text{-}LMA_i[k]|)\div(|SMA_i[k]\text{-}LMA_i[k]|_{av})$$

In Equation 6, |SMA$_i$[k]-LMA$_i$[k]| represents the short- and long-term average difference of the i$^{th}$ battery cell BC$_i$ at the current time point, |SMA$_i$[k]-LMA$_i$[k]|$_{av}$ represents an average value (normalization criterion value) of the short- and long-term average differences of all battery cells, and D$^*_{diag,i}$[k] represents the normalized cell diagnosis deviation of the i$^{th}$ battery cell BC$_i$ at the current time point. The symbol '*' represents that the parameter has been normalized.

The short- and long-term average difference |SMA$_i$[k]-LMA$_i$[k]| of each battery cell BC$_i$ may also be normalized through the logarithmic operation in Equation 7 below. In this embodiment, the value calculated by Equation 7 may also be called the normalized cell diagnosis deviation D$^*_{diag,i}$[k].

<Equation 7>

$$D^*_{diag,i}[k] = Log|SMA_i[k]\text{-}LMA_i[k]|$$

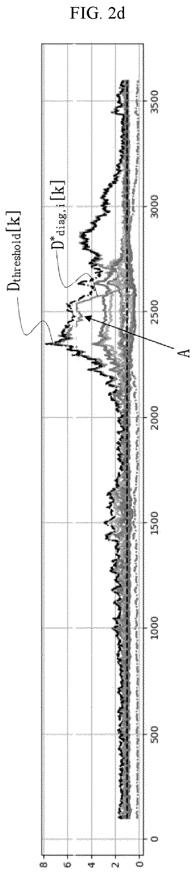

FIG. 2d shows the change over time in the normalized cell diagnosis deviation D$^*_{diag,i}$[k] of each battery cell BC$_i$. The cell diagnosis deviation D$^*_{diag,i}$[k] is calculated using Equation 6. In FIG. 2d, the horizontal axis represents time, and the vertical axis represents the cell diagnosis deviation D$^*_{diag,i}$[k] of each battery cell BC$_i$.

Referring to FIG. 2d, it may be found that the change in the short- and long-term average difference of each battery cell BC$_i$ has been amplified based on the average value as the short- and long-term average difference |SMA$_i$[k]-LMA$_i$[k]| of each battery cell BC$_i$ is normalized. As a result, a voltage abnormality of the battery cell may be diagnosed more accurately.

Preferably, the control circuit 220 may diagnose a voltage abnormality of each battery cell BC$_i$ by comparing the normalized cell diagnosis deviation D$^*_{diag,i}$[k] with a statistical variable threshold D$_{threshold}$[k].

Preferably, the control circuit 220 may set the statistical variable threshold D$_{threshold}$[k] per unit time using Equation 8 below.

<Equation 8>

$$D_{threshold}[k] = \beta*Sigma(D^*_{diag,i}[k])$$

In Equation 8, Sigma is a function that calculates a standard deviation for the normalized cell diagnosis deviation D$^*_{diag,i}$[k] of all battery cells BC at time index k. Also, β is a constant determined experimentally. β is a factor that determines diagnostic sensitivity. β may be appropriately determined by trial and error such that, when the present disclosure is implemented on the cell group containing a battery cell actually having a voltage abnormality, the corresponding battery cell may be detected as a voltage abnormal cell. In one example, β may be set to at least 5 or more, or at least 6 or more, or at least 7 or more, or at least 8 or more, or at least 9 or more. D$_{threshold}$[k] generated by Equation 8 is plural, so it constitutes time series data.

Meanwhile, the normalized cell diagnosis deviation D$^*_{diag,i}$[k] of a battery cell with voltage abnormality is relatively larger than that of a normal battery cell. Therefore, in order to improve the accuracy and reliability of diagnosis, it is recommended to exclude max(D$^*_{diag,i}$[k]), which corresponds to a maximum value, when calculating Sigma(D$^*_{diag,i}$[k]) at time index k. Here, max is a function that returns the maximum value for the plurality of input variables, and the input variables are the normalized cell diagnosis deviations D$^*_{diag,i}$[k] of all battery cells.

In FIG. 2d, the time series data representing the time change of statistical variable threshold D$_{threshold}$[k] corresponds to a profile displayed in the darkest color among all profiles.

The control circuit 220 may determine the statistical variable threshold D$_{threshold}$[k] at time index k and then determine the filter diagnosis value D$_{filter,i}$[k] by filtering the normalized cell diagnosis deviation D$^*_{diag,i}$[k] of each battery cell BC$_i$ using Equation 9 below.

Two values may be assigned to the filter diagnosis value D$_{filter,i}$[k] for each battery cell BC$_i$. In other words, if the cell diagnosis deviation D$^*_{diag,i}$[k] is greater than the statistical variable threshold D$_{threshold}$[k], the difference value between the cell diagnosis deviation D$^*_{diag,i}$[k] and the statistical variable threshold D$_{threshold}$[k] is assigned to the filter diagnosis value D$_{filter,i}$[k]. Meanwhile, if the cell diagnosis deviation D$^*_{diag,i}$[k] is equal to or smaller than the statistical variable threshold $D_{threshold}[k]$, 0 is assigned to the filter diagnosis value $D_{filter,i}[k]$.

<Equation 9>

$$D_{filter,i}[k] = D^*_{diag,i}[k] - D_{threshold}[k] \ (IF \ D^*_{diag,i}[k] > D_{threshold}[k])$$

$$D_{filter,i}[k] = 0 \ (IF \ D^*_{diag,i}[k] \leq D_{threshold}[k])$$

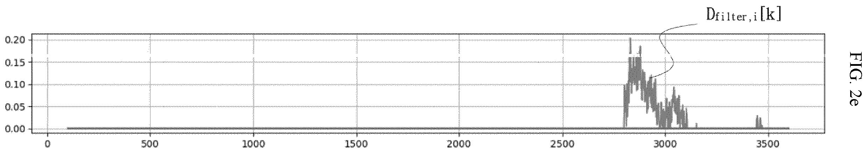

FIG. 2e is a diagram showing time series data of the filter diagnosis value $D_{filter,i}[k]$ obtained by filtering the cell diagnosis deviation $D^*_{diag,i}[k]$ at time index k.

Referring to FIG. 2e, an irregular pattern in which the filter diagnosis value $D_{filter,i}[k]$ of a specific battery cell has a positive value around 3000 seconds is confirmed. For reference, a specific battery cell with an irregular pattern is a battery cell with the time series data indicated by A in FIG. 2d.

In one example, the control circuit 220 may integrate a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the integrated time is greater than a preset criterion time as a voltage abnormal cell.

Preferably, the control circuit 220 may integrate a time period in which the condition that the filter diagnosis value $D_{filter,i}[k]$ is greater than the diagnosis threshold is continuously satisfied. If there are multiple time periods, the control circuit 220 may independently calculate the integrated time at each time period.

In another example, the control circuit 220 may integrate the number of data included in a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the number of integrated data is greater than a preset criterion count as a voltage abnormal cell.

Preferably, the control circuit 220 may only integrate the number of data included in the time period in which the condition that the filter diagnosis value $D_{filter,i}[k]$ is greater than the diagnosis threshold is continuously satisfied. If there are multiple time periods, the control circuit 220 may independently integrate the number of data in each time period.

Meanwhile, the control circuit 220 may replace $V_i[k]$ in Equations 1 to 5 with the normalized cell diagnosis deviation $D^*_{diag,i}[k]$ of each battery cell $BC_i$ shown in FIG. 2d. In addition, at time index k, in a recursive way, the control circuit 220 may calculate a short- and long-term average difference $|SMA_i[k]-LMA_i[k]|$ of the cell diagnosis deviation $D^*_{diag,i}[k]$ , calculate an average value of the short- and long-term average difference $|SMA_i[k]-LMA_i[k]|$ of the cell diagnosis deviation $D^*_{diag,i}[k]$, calculate a cell diagnosis deviation $D^*_{diag,i}[k]$ corresponding to the difference of the short- and long-term average difference $|SMA_i[k]-LMA_i[k]|$ compared to the average value, calculate a normalized cell diagnosis deviation $D^*_{diag,i}[k]$ for the short- and long-term average difference $|SMA_i[k]-LMA_i[k]|$ using Equation 6, determine a statistical variable threshold $D_{threshold}[k]$ for the normalized cell diagnosis deviation $D^*_{diag,i}[k]$ using Equation 8, determine a filter diagnosis value $D_{filter,i}[k]$ by filtering the cell diagnosis deviation $D^*_{diag,i}[k]$ using Equation 9, and diagnose voltage abnormality of the battery cell using the time series data of the filter diagnosis value $D_{filter,i}[k]$.

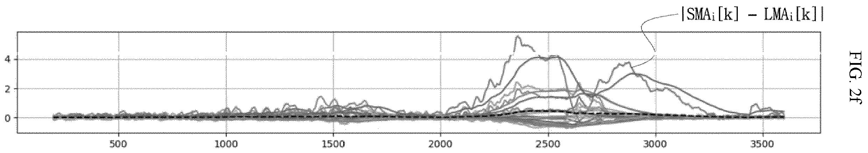

FIG. 2f is a graph showing the change over time in the short- and long-term average difference $|SMA_i[k]-LMA_i[k]|$ for the time series data (FIG. 2d) of the normalized cell diagnosis deviation $D^*_{diag,i}[k]$. In Equations 2, 4 and 5 used to calculate the short- and long-term average difference $|SMA_i[k]-LMA_i[k]|$, $V_i[k]$ is may be replaced with $D^*_{diag,i}[k]$, and $V_{av}[k]$ may be replaced with the average value of $D^*_{diag,i}[k]$.

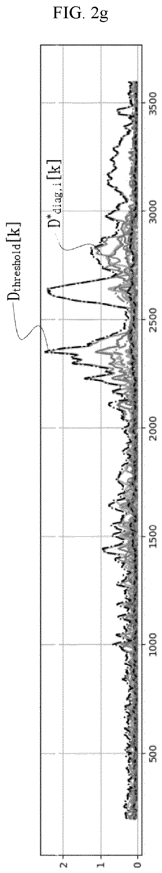

FIG. 2g is a graph showing the time series data of the normalized cell diagnosis deviation $D^*_{diag,i}[k]$ calculated using Equation 6. In FIG. 2g, the time series data of the statistical variable threshold $D_{threshold}[k]$ corresponds to a profile displayed in the darkest color.

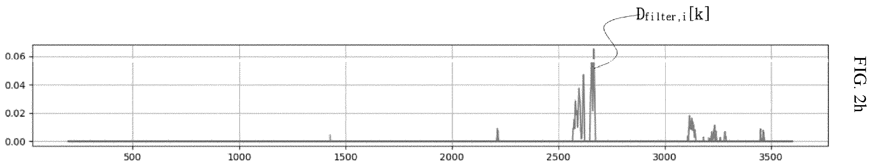

FIG. 2h is a profile showing the time series data of the filter diagnosis value $D_{filter,i}[k]$ obtained by filtering the time series data of the cell diagnosis deviation $D^*_{diag,i}[k]$ using Equation 9.

In one example, the control circuit 220 may integrate a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the integrated time is greater than a preset criterion time as a voltage abnormal cell.

Preferably, the control circuit 220 may integrate a time period in which the condition that the filter diagnosis value $D_{filter,i}[k]$ is greater than the diagnosis threshold is continuously satisfied. If there are multiple time periods, the control circuit 220 may independently calculate the integrated time in each time period.

In another example, the control circuit 220 may integrate the number of data included in a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the number of integrated data is greater than a preset criterion count as a voltage abnormal cell.

Preferably, the control circuit 220 may only integrate the number of data included in the time period in which the condition that the filter diagnosis value $D_{filter,i}[k]$ is greater than the diagnosis threshold is continuously satisfied. If there are multiple time periods, the control circuit 220 may independently integrate the number of data in each time period.

The control circuit 220 may additionally repeat the above-described recursive calculation process as many times as a criterion number. That is, the control circuit 220 may replace the voltage time series data shown in FIG. 2a with the time series data of the normalized cell diagnosis deviation $D^*_{diag,i}[k]$ (for example, the data in FIG. 2g). In addition, at time index k, in a recursive way, the control circuit 220 may calculate a short- and long-term average difference $|SMA_i[k]-LMA_i[k]|$, calculate an average value of the short- and long-term average difference $|SMA_i[k]-LMA_i[k]|$, calculate a cell diagnosis deviation $D^*_{diag,i}[k]$ corresponding to the difference of the short- and long-term average difference $|SMA_i[k]-LMA_i[k]|$ compared to the average value, calculate a normalized cell diagnosis deviation $D^*_{diag,i}[k]$ for the short- and long-term average difference $|SMA_i[k]-LMA_i[k]|$ using Equation 6, determine a statistical variable threshold $D_{threshold}[k]$ for the cell diagnosis deviation $D^*_{diag,i}[k]$ using Equation 8, determine a filter diagnosis value $D_{filter,i}[k]$ by filtering the cell diagnosis deviation $D^*_{diag,i}[k]$ using Equation 9, and diagnose voltage abnormality of the battery cell using the time series data of the filter diagnosis value $D_{filter,i}[k]$.

If the above recursive calculation process is repeated, voltage abnormality of the battery cell may be diagnosed more precisely. That is, referring to FIG. 2e, a positive profile pattern is observed only in two time periods in the time series data of the filter diagnosis value $D_{filter,i}[k]$ of the battery cell in which voltage abnormality has occurred. However, referring to FIG. 2h, a positive profile pattern is observed in more time periods than in FIG. 2e in the time series data of the filter diagnosis value $D_{filter,i}[k]$ of the battery cell in which voltage abnormality has occurred. Therefore, if the recursive calculation process is repeated, the time point at which voltage abnormality of the battery cell occurs may be detected more accurately.

The battery diagnosis operations of the control circuit 220 according to the above embodiments (modifications) are preferably executed under diagnostic conditions that, as shown in FIG. 2a, the profile regarding the time series data of the cell voltage of each battery cell $BC_i$ includes voltage data equal to or less than a preset diagnosis start voltage and an inflection point is included after the time point at which the voltage data is measured. The diagnosis start voltage may be set to be higher than the lower discharge limit voltage of each battery cell $BC_i$ by a predetermined level. The predetermined level may vary depending on the type of the battery cell $BC_i$ and the degree of degradation of the battery cell $BC_i$. In the profiles related to the time series data of the cell voltage shown in FIG. 2a, the diagnosis start voltage may be set to 3.35V. The inflection point may appear when the discharging is stopped for a certain period while each battery cell $BC_i$ is being discharged. In one example, when the electric vehicle 1 stops to wait for a sign in the key-on state, an inflection point may be included in the profile regarding the time series data of the cell voltage of each battery cell $BC_i$. The inflection point may appear in the process of resolving the polarization of the electrodes when the discharge of each battery cell $BC_i$ is stopped.

If the battery diagnosis operations of the control circuit 220 are executed under the above desirable diagnosis conditions, the voltage abnormality of the battery cell with voltage abnormality is amplified compared to other battery cells, thereby improving the accuracy and reliability of battery diagnosis.

Hereinafter, a battery diagnosing method using the battery diagnosing apparatus 200 of the present disclosure described above will be described in detail. The battery diagnosing method may be performed by the battery diagnosing apparatus 200 while the electric vehicle 1 is operating. Here, the operation of the electric vehicle 1 may include moving of the electric vehicle 1, parking, or waiting for a sign.

The operations of the control circuit 220 will be described in more detail in various embodiments of the battery diagnosing method.

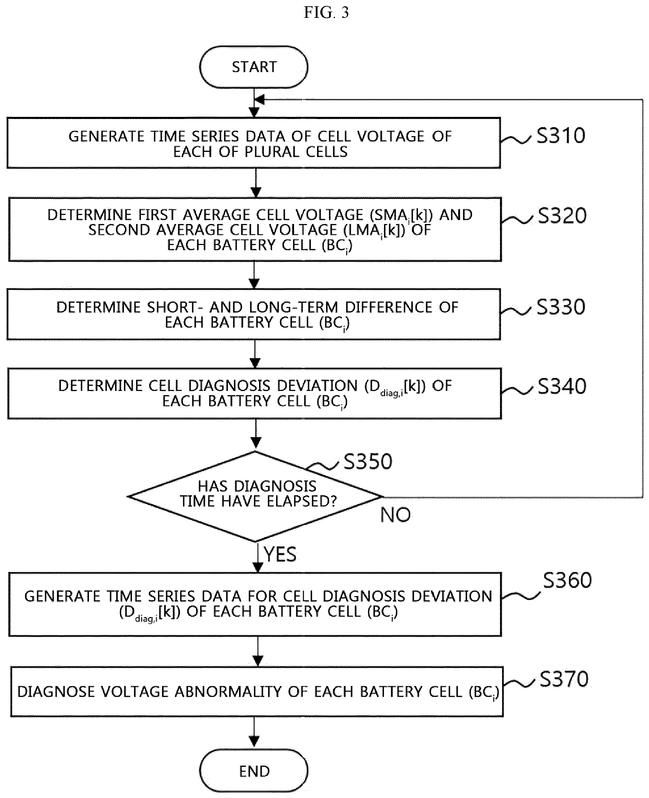

FIG. 3 is an exemplary flowchart showing a battery diagnosis method according to the first embodiment of the present disclosure. The method of FIG. 3 may be periodically executed per unit time by the control circuit 220 while the electric vehicle 1 is operating.

Referring to FIGS. 1 to 3, in Step S310, the control circuit 220 collects a voltage signal representing the cell voltage of each of the plurality of battery cells $BC_1$ to $BC_N$ from the voltage sensing circuit 210, and generates time series data of the cell voltage of each battery cell $BC_i$ (see FIG. 2a). In the time series data of the cell voltage, the number of data increases by 1 whenever the unit time elapses.

Preferably, $V_i[k]$ or $VD_i[k]$ of Equation 5 may be used as the cell voltage.

In Step S320, the control circuit 220 determines the first average cell voltage $SMA_i[k]$ (see Equations 1 and 2) and the second average cell voltage $LMA_i[k]$ (see Equations 3 and 4) of each battery cell $BC_i$, based on the time series data of the cell voltage of each battery cell $BC_i$ (see FIG. 2b). The first average cell voltage $SMA_i[k]$ is the short-term movement average of the cell voltage of each battery cell $BC_i$ over the first moving window with a first time length. The second average cell voltage $LMA_i[k]$ is the long-term movement average of the cell voltage of each battery cell $BC_i$ over the second moving window with a second time length. When calculating the first average cell voltage $SMA_i[k]$ and the second average cell voltage $LMA_i[k]$, $V_i[k]$ or $VD_i[k]$ may be used.

In Step S330, the control circuit 220 determines the short- and long-term average difference $|SMA_i[k]-LMA_i[k]|$ of each battery cell $BC_i$ (see FIG. 2c).

In Step S340, the control circuit 220 determines the cell diagnosis deviation $D_{diag,i}[k]$ of each battery cell $BC_i$. The cell diagnosis deviation $D_{diag,i}[k]$ is the deviation between the short- and long-term average difference $|SMA_i[k]-LMA_i[k]|$ of the $i^{th}$ battery cell $BC_i$ and the average value $|SMA_i[k]-LMA_i[k]|_{av}$ of the short- and long-term average differences for all battery cells.

In Step S350, the control circuit 220 judges whether the diagnosis time has elapsed. The diagnosis time is set in advance. If the judgment of Step S350 is YES, Step S360 proceeds, and if the judgment of Step S350 is NO, Steps S310 to S340 are repeated again.

In Step S360, the control circuit 220 generates time series data for the cell diagnosis deviation $D_{diag,i}[k]$ of each battery cell $BC_i$ collected during the diagnosis time.

In Step S370, the control circuit 220 diagnoses a voltage abnormality of each battery cell $BC_i$ by analyzing the time series data for the cell diagnosis deviation $D_{diag,i}[k]$.

In one example, the control circuit 220 may integrate a time period in which the cell diagnosis deviation $D_{diag,i}[k]$ is greater than a diagnosis threshold (e.g., 0.015) in the time series data for the cell diagnosis deviation $D_{diag,i}[k]$ of each battery cell $BC_i$, and diagnose a battery cell satisfying the condition that the integrated time is greater than a preset criterion time as a voltage abnormal cell.

Preferably, the control circuit 220 may integrate only time periods in which the condition that the cell diagnosis deviation $D_{diag,i}[k]$ is greater than the diagnosis threshold is continuously satisfied. If there are multiple time periods, the control circuit 220 may independently calculate the integrated time in each time period.

In another example, the control circuit 220 may integrate the number of data in which the cell diagnosis deviation $D_{diag,i}[k]$ is greater than the diagnosis threshold (e.g., 0.015) in the time series data for the cell diagnosis deviation $D_{diag,i}[k]$ of each battery cell $BC_i$, and diagnose a battery cell satisfying the condition that the number of integrated data is greater than a preset criterion count as a voltage abnormal cell.

Preferably, the control circuit 220 may integrate only the number of data included in the time period in which the condition that the cell diagnosis deviation $D_{diag,i}[k]$ is greater than the diagnosis threshold is continuously satisfied. If there are multiple time periods, the control circuit 220 may independently integrate the number of data in each time period.

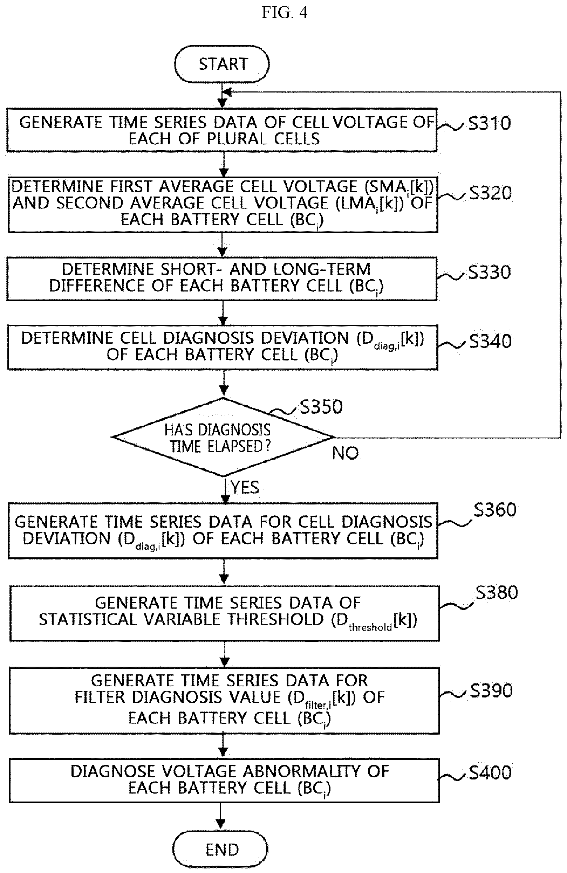

FIG. 4 is an exemplary flowchart showing a battery diagnosis method according to the second embodiment of the present disclosure. The method of FIG. 4 may be periodically executed per unit time by the control circuit 220 while the electric vehicle 1 is operating.

In the battery diagnosing method of the second embodiment, Steps S310 to S360 are substantially the same as the first embodiment, and thus will not be described in detail. After Step S360, Step S380 proceeds.

In Step S380, the control circuit 220 generates time series data of the statistical variable threshold $D_{threshold}[k]$ using Equation 8. The input to the Sigma function in Equation 8 is the time series data for the cell diagnosis deviations $D_{diag,i}[k]$ of all battery cells generated in Step S360. Preferably, the maximum value of the cell diagnosis deviations $D_{diag,i}[k]$ may be excluded from the input value of the Sigma function. The cell diagnosis deviation $D_{diag,i}[k]$ is a deviation of the short- and long-term average difference $|SMA_i[k]-LMA_i[k]|$ compared to the average value.

In Step S390, the control circuit 220 generates time series data of the filter diagnosis value $D_{filter,i}[k]$ by filtering the cell diagnosis deviation $D_{diag,i}[k]$ of each battery cell $BC_i$ using Equation 9.

When using Equation 9, $D^*_{diag,i}[k]$ may be replaced with $D_{diag,i}[k]$.

In Step S400, the control circuit 220 diagnoses a voltage abnormality of each battery cell $BC_i$ by analyzing the time series data of the filter diagnosis value $D_{filter,i}[k]$.

In one example, the control circuit 220 may integrate a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the integrated time is greater than a preset criterion time as a voltage abnormal cell.

Preferably, the control circuit 220 may integrate only time periods in which the condition that the filter diagnosis value $D_{filter,i}[k]$ is greater than the diagnosis threshold is continuously satisfied. If there are multiple time periods, the control circuit 220 may independently calculate the integrated time in each time period.

In another example, the control circuit 220 may integrate the number of data included in a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the number of integrated data is greater than a preset criterion count as a voltage abnormal cell.

Preferably, the control circuit 220 may integrate only the number of data included in the time period in which the condition that the filter diagnosis value $D_{filter,i}[k]$ is greater than the diagnosis threshold is continuously satisfied. If there are multiple time periods, the control circuit 220 may independently integrate the number of data in each time period.

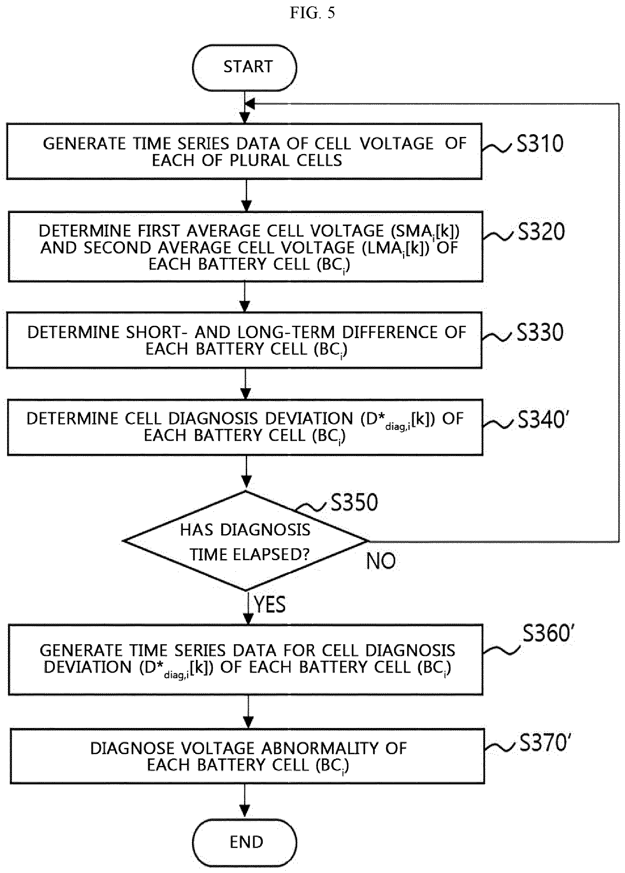

FIG. 5 is an exemplary flowchart showing a battery diagnosis method according to the third embodiment of the present disclosure. The method of FIG. 5 may be periodically executed per unit time by the control circuit 220 while the electric vehicle 1 is operating.

The battery diagnosing method according to the third embodiment is substantially the same as the first embodiment, except that Steps S340, S360 and S370 are changed to Step S340', 360' and Step S370', respectively. Therefore, for the third embodiment, only features with differences will be described.

In Step S340', the control circuit 220 determines the normalized cell diagnosis deviation $D^*_{diag,i}[k]$ for the short- and long-term average difference $|SMA_i[k]-LMA_i[k]|$ of each battery cell $BC_i$ using Equation 6. The normalization criterion value is an average value of the short- and long-term average difference $|SMA_i[k]-LMA_i[k]|$. Equation 6 may be replaced with Equation 7.

In Step S360', the control circuit 220 generates time series data for the normalized cell diagnosis deviation $D^*_{diag,i}[k]$ of each battery cell $BC_i$ collected during the diagnosis time (see FIG. 2d).

In Step S370', the control circuit 220 diagnoses a voltage abnormality of each battery cell $BC_i$ by analyzing the time series data for the normalized cell diagnosis deviation $D^*_{diag,i}[k]$.

In one example, the control circuit 220 may integrate a time period in which the normalized cell diagnosis deviation $D^*_{diag,i}[k]$ is greater than a diagnosis threshold (e.g., 4) in the time series data for the normalized cell diagnosis deviation $D^*_{diag,i}[k]$ of each battery cell $BC_i$, and diagnose a battery cell satisfying the condition that the integrated time is greater than a preset criterion time as a voltage abnormal cell.

Preferably, the control circuit 220 may integrate only time periods in which the condition that the normalized cell diagnosis deviation $D^*_{diag,i}[k]$ is greater than the diagnosis threshold is continuously satisfied. If there are multiple time periods, the control circuit 220 may independently calculate the integrated time in each time period.

In another example, the control circuit 220 may integrate the number of data in which the normalized cell diagnosis deviation is greater than the diagnosis threshold (e.g., 4) in the time series data for the normalized cell diagnosis deviation $D^*_{diag,i}[k]$ of each battery cell $BC_i$, and diagnose a battery cell satisfying the condition that the number of integrated data is greater than a preset criterion count as a voltage abnormal cell.

Preferably, the control circuit 220 may integrate only the number of data included in the time period in which the condition that the normalized cell diagnosis deviation $D^*_{diag,i}[k]$ is greater than the diagnosis threshold is continuously satisfied. If there are multiple time periods, the control circuit 220 may independently integrate the number of data in each time period.

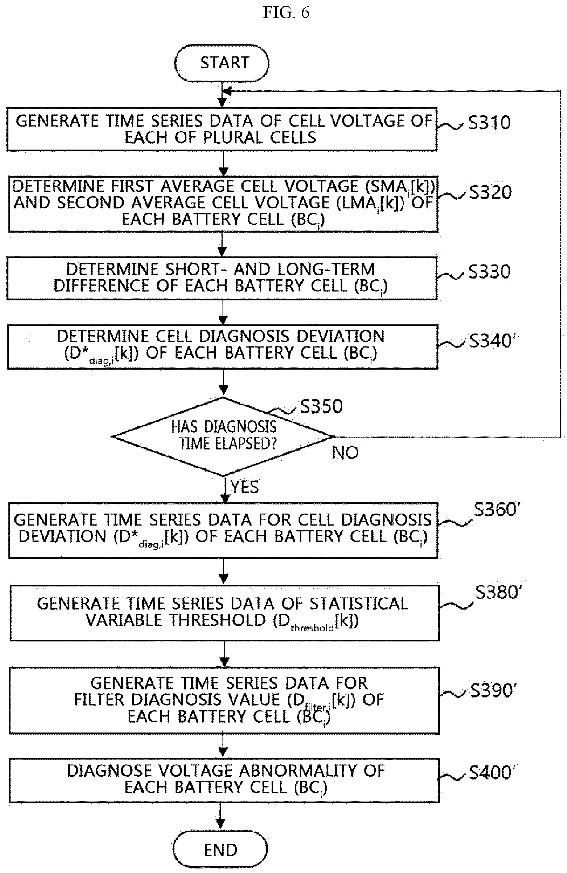

FIG. 6 is an exemplary flowchart showing a battery diagnosis method according to the fourth embodiment of the present disclosure. The method of FIG. 6 may be periodically executed per unit time by the control circuit 220 while the electric vehicle 1 is operating.

The battery diagnosing method according to the fourth embodiment is substantially the same as the second embodiment, except that Steps S340, S360, S380, S390 and S400 are changed to Step S340', S360', S380', S390' and S400', respectively. Therefore, for the fourth embodiment, only features different from the second embodiment will be described.

In Step S340', the control circuit 220 determines the normalized cell diagnosis deviation $D^*_{diag,i}[k]$ for the short- and long-term average difference $|SMA_i[k]-LMA_i[k]|$ of each battery cell $BC_i$ using Equation 6. The normalization criterion value is an average value of the short- and long-term average difference $|SMA_i[k]-LMA_i[k]|$. Equation 6 may be replaced with Equation 7.

In Step S360', the control circuit 220 generates time series data for the normalized cell diagnosis deviation $D^*_{diag,i}[k]$ of each battery cell $BC_i$ collected during the diagnosis time (see FIG. 2d).

In Step S380', the control circuit 220 generates time series data of the statistical variable threshold $D_{threshold}[k]$ using Equation 8. The input to the Sigma function in Equation 8 is the time series data for the normalized cell diagnosis deviations $D^*_{diag,i}[k]$ of all battery cells generated in Step S360'. Preferably, at each time index, the maximum value of the normalized cell diagnosis deviations $D^*_{diag,i}[k]$ may be excluded from the input value of the Sigma function.

In Step S390', the control circuit 220 generates time series data of the filter diagnosis value $D_{filter,i}[k]$ by filtering the normalized cell diagnosis deviation $D^*_{diag,i}[k]$ of each battery cell $BC_i$ based on the statistical variable threshold $D_{threshold}[k]$ using Equation 9.

In Step S400', the control circuit 220 diagnoses a voltage abnormality of each battery cell $BC_i$ by analyzing the time series data of the filter diagnosis value $D_{filter,i}[k]$.

In one example, the control circuit 220 may integrate a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the integrated time is greater than a preset criterion time as a voltage abnormal cell.

Preferably, the control circuit 220 may integrate only time periods in which the condition that the filter diagnosis value $D_{filter,i}[k]$ is greater than the diagnosis threshold is continuously satisfied. If there are multiple time periods, the control circuit 220 may independently calculate the integrated time in each time period.

In another example, the control circuit 220 may integrate the number of data included in a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the number of integrated data is greater than a preset criterion count as a voltage abnormal cell.

Preferably, the control circuit 220 may integrate only the number of data included in the time period in which the condition that the filter diagnosis value $D_{filter,i}[k]$ is greater than the diagnosis threshold is continuously satisfied. If there are multiple time periods, the control circuit 220 may independently integrate the number of data in each time period.

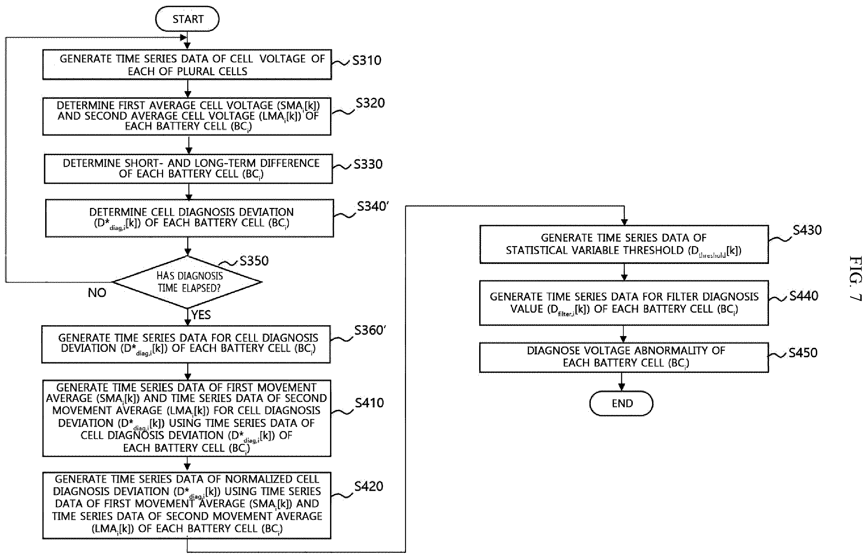

FIG. 7 is an exemplary flowchart showing a battery diagnosis method according to the fifth embodiment of the present disclosure.

In the fifth embodiment, Steps S310 to Step S360' are substantially the same as those of the fourth embodiment. Therefore, for the fifth embodiment, only features different from the fourth embodiment will be described.

In Step S410, the control circuit 220 generates time series data of a first movement average $SMA_i[k]$ and time series data of a second movement average $LMA_i[k]$ for the cell diagnosis deviation $D^*_{diag,i}[k]$ using the time series data of the normalized cell diagnosis deviation $D^*_{diag,i}[k]$ of each battery cell $BC_i$ (see FIG. 2f).

In Step S420, the control circuit 220 generates time series data of a normalized cell diagnosis deviation $D^*_{diag,i}[k]$ using the time series data of the first movement average $SMA_i[k]$ and the time series data of the second movement average $LMA_i[k]$ of each battery cell $BC_i$ using Equation 6 (see FIG. 2g).

In Step S430, the control circuit 220 generates time series data of a statistical variable threshold $D_{threshold}[k]$ using Equation 8 (see FIG. 2g).

In Step S440, the control circuit 220 generates time series data for a filter diagnosis value $D_{filter,i}[k]$ of each battery cell $BC_i$ based on the statistical variable threshold $D_{threshold}[k]$ using Equation 9 (see FIG. 2h).

In Step S450, the control circuit 220 diagnoses a voltage abnormality of each battery cell $BC_i$ by analyzing the time series data of the filter diagnosis value $D_{filter,i}[k]$ of each battery cell $BC_i$.

In one example, the control circuit 220 may integrate a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the integrated time is greater than a preset criterion time as a voltage abnormal cell.

Preferably, the control circuit 220 may integrate a time period in which the condition that the filter diagnosis value $D_{filter,i}[k]$ is greater than the diagnosis threshold is continuously satisfied. If there are multiple time periods, the control circuit 220 may independently calculate the integrated time in each time period.

In another example, the control circuit 220 may integrate the number of data included in a time period in which the filter diagnosis value $D_{filter,i}[k]$ is greater than a diagnosis threshold (e.g., 0) in the time series data of the filter diagnosis value $D_{filter,i}[k]$ for each battery cell $BC_i$, and diagnose a battery cell satisfying the condition that the number of integrated data is greater than a preset criterion count as a voltage abnormal cell.

Preferably, the control circuit 220 may integrate only the number of data included in the time period in which the condition that the filter diagnosis value $D_{filter,i}[k]$ is greater than the diagnosis threshold is continuously satisfied. If there are multiple time periods, the control circuit 220 may independently integrate the number of data in each time period.

In the fifth embodiment, the control circuit 220 may recursively perform Steps S410 and S420 two or more times. In other words, the control circuit 220 may generate time series data of a first movement average $SMA_i[k]$ and time series data of a second movement average $LMA_i[k]$ for the cell diagnosis deviation $D^*_{diag,i}[k]$ again in Step S410 using the time series data of the normalized cell diagnosis deviation $D^*_{diag,i}[k]$ generated in Step S420. Then, in Step S420, the control circuit 220 may generate time series data of a normalized cell diagnosis deviation $D^*_{diag,i}[k]$ again based on Equation 6 using the time series data of the first movement average $SMA_i[k]$ and the time series data of the second movement average $LMA_i[k]$ of each battery cell $BC_i$. This recursive algorithm may be repeated a set number of times.

When Steps S410 and S420 are performed according to the recursive algorithm, Steps S430 to S450 may be performed using the time series data of the normalized cell diagnosis deviation $D^*_{diag,i}[k]$ finally calculated through the recursive algorithm.

The battery diagnosing method according to the above embodiments (modifications) are preferably executed under diagnostic conditions that, as shown in FIG. 2a, the profile regarding the time series data of the cell voltage of each battery cell $BC_i$ includes voltage data equal to or less than a preset diagnosis start voltage and an inflection point is included after the time point at which the voltage data is measured. The diagnosis start voltage may be set to be higher than the lower discharge limit voltage of each battery cell $BC_i$ by a predetermined level. The predetermined level may vary depending on the type of the battery cell $BC_i$ and the degree of degradation of the battery cell $BC_i$. In the profiles related to the time series data of the cell voltage shown in FIG. 2a, the diagnosis start voltage may be set to 3.35V. The inflection point may appear when the discharging is stopped for a certain period while each battery cell $BC_i$ is being discharged. In one example, when the electric vehicle 1 stops to wait for a sign in the key-on state, an inflection point may be included in the profile regarding the time series data of the cell voltage of each battery cell $BC_i$. The inflection point may appear in the process of resolving the polarization of the electrodes when the discharge of each battery cell $BC_i$ is stopped.

If the battery diagnosing method according to the above embodiments (modifications) are executed under the above desirable diagnosis conditions, the voltage abnormality of the abnormal battery cell is amplified compared to other battery cells, thereby improving the accuracy and reliability of battery diagnosis.

In an embodiment of the present disclosure, after the control circuit 220 diagnoses a voltage abnormality on all battery cells, if a voltage abnormality is diagnosed in a specific battery cell(s), the control circuit 220 may output the diagnosis result information through a display unit (not shown). In addition, the control circuit 220 may record the identification information (ID) of the battery cell at which a voltage abnormality is diagnosed, the time point at which the voltage abnormality is diagnosed, and a diagnosis flag in the memory unit 221.

Preferably, the diagnosis result information may include a message representing that the cell group has a cell with voltage abnormality. Optionally, the diagnosis result information may include a warning message representing that detailed inspection of battery cells is necessary.

In one example, the display unit may be included in a load device that receives power from the cell group CG. If the load device is an electric vehicle, a hybrid electric vehicle, a plug-in hybrid vehicle, or the like, the diagnosis result information may be output through an integrated information display of the vehicle. In another example, when the battery diagnosing apparatus 200 according to the present disclosure is included in a diagnosing system, the diagnosis result may be output through a display provided in the diagnosing system.

Preferably, the battery diagnosing apparatus 200 according to the embodiment of the present disclosure may be included in the battery management system 100 or a control system of the load device (not shown).

According to the above embodiments, at every unit time, two movement averages of the cell voltage of each battery cell for two different time lengths may be determined, and based on the difference between the two movement averages of each of the plurality of battery cells, a voltage abnormality of each battery cell may be diagnosed efficiently and accurately.

According to another embodiment of the present disclosure, the voltage abnormality of each battery cell may be accurately diagnosed by applying an advanced technique such as normalization and/or statistical variable threshold in analyzing the change trend difference between the two movement averages of each battery cell.

According to still another embodiment of the present disclosure, the time period in which the voltage abnormality of each battery cell has occurred and/or the voltage abnormality detection count may be precisely detected by analyzing the time series data of the filter diagnosis value determined based on the statistical variable threshold.

The embodiments of the present disclosure described hereinabove are not implemented only through the apparatus and method, and may be implemented through programs that perform the functions corresponding to the configurations of the embodiments of the present disclosure or recording media having the programs recorded thereon, and such implementation may be easily achieved by those skilled in the art from the disclosure of the embodiments described above.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the scope of the appended claims.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and all or some of the embodiments may be selectively combined to allow various modifications.

**Claims**

1.    A battery diagnosing apparatus (200) for a cell group (CG), which includes a plurality of battery cells ($BC_1$ ... $BC_N$) connected in series and is mounted in an electric vehicle (1), the battery diagnosing apparatus comprising:

   a voltage sensing circuit (210) configured to periodically generate a voltage signal representing a cell voltage of each battery cell while the electric vehicle is operating; and
   a control circuit (220) configured to accumulatively store the cell voltage determined from the voltage signal in a memory unit and generate time series data representing the change over time in the cell voltage of each battery cell by using the accumulated cell voltage of each battery cell,
   wherein the control circuit is configured to:

      (i) determine a first average cell voltage and a second average cell voltage of each battery cell based on the time series data, where the first average cell voltage is a short-term movement average, and the second average cell voltage is a long-term movement average, and
      (ii) detect a voltage abnormality of each battery cell based on the difference between the first average cell voltage and the second average cell voltage.

2.    The battery diagnosing apparatus according to claim 1,

wherein for each battery cell, the control circuit is configured to determine a short- and long-term average difference corresponding to the difference between the first average cell voltage and the second average cell voltage,

wherein for each battery cell, the control circuit is configured to determine a cell diagnosis deviation corresponding to a deviation between the short- and long-term average difference of the battery cell and an average value of short- and long-term average differences of all battery cells, and

wherein the control circuit is configured to detect a battery cell satisfying a condition that the cell diagnosis deviation exceeds a diagnosis threshold as a voltage abnormal cell.

3. The battery diagnosing apparatus according to claim 2,
wherein for each battery cell, the control circuit is configured to generate time series data of the cell diagnosis deviation and detect a voltage abnormality of the battery cell from the time at which the cell diagnosis deviation exceeds the diagnosis threshold or the number of data of the cell diagnosis deviation exceeding the diagnosis threshold.

4. The battery diagnosing apparatus according to claim 1,

wherein for each battery cell, the control circuit is configured to determine a short- and long-term average difference corresponding to the difference between the first average cell voltage and the second average cell voltage,

wherein for each battery cell, the control circuit is configured to determine a cell diagnosis deviation by calculating a deviation between the short- and long-term average difference of the battery cell and an average value of short- and long-term average differences of all battery cells,

wherein the control circuit is configured to determine a statistical variable threshold that depends on a standard deviation of the cell diagnosis deviations of all battery cells,

wherein the control circuit is configured to generate time series data of a filter diagnosis value by filtering the time series data on the cell diagnosis deviation of each battery cell based on the statistical variable threshold, and

wherein the control circuit is configured to detect a voltage abnormality of the battery cell from the time at which the filter diagnosis value exceeds a diagnosis threshold or the number of data of the filter diagnosis value that exceeds the diagnosis threshold.

5. The battery diagnosing apparatus according to claim 1,

wherein for each battery cell, the control circuit is configured to determine a short- and long-term average difference corresponding to the difference between the first average cell voltage and the second average cell voltage,

wherein for each battery cell, the control circuit is configured to determine a normalized value of the short- and long-term average difference as a normalized cell diagnosis deviation and determine a statistical variable threshold that depends on a standard deviation for the normalized cell diagnosis deviations of all battery cells,

wherein the control circuit is configured to generate time series data of the filter diagnosis value by filtering the time series data on the normalized cell diagnosis deviation of each battery cell based on the statistical variable threshold, and

wherein the control circuit is configured to detect a voltage abnormality of the battery cell from the time at which the filter diagnosis value exceeds a diagnosis threshold or the number of data of the filter diagnosis value that exceeds the diagnosis threshold.

6. The battery diagnosing apparatus according to claim 5,
wherein the control circuit is configured to normalize the short- and long-term average difference for each battery cell by dividing the short- and long-term average difference by an average value of short- and long-term average differences of all battery cells.

7. The battery diagnosing apparatus according to claim 5,
wherein the control circuit is configured to normalize the short- and long-term average difference for each battery cell by calculating the logarithm of the short- and long-term average difference.

8. The battery diagnosing apparatus according to claim 1,
wherein the control circuit is configured to generate time series data representing the change over time in the cell voltage of each battery cell using a voltage difference between an average value of the cell voltages of all battery cells and the cell voltage of each battery cell measured per unit time.

9. The battery diagnosing apparatus according to claim 1,

wherein for each battery cell, the control circuit is configured to determine a short- and long-term average difference corresponding to the difference between the first average cell voltage and the second average cell voltage,

wherein for each battery cell, the control circuit is configured to determine a normalized value of the short- and long-term average difference as a normalized cell diagnosis deviation and generate time series data of the normalized cell diagnosis deviation for each battery cell,

wherein the control circuit is configured to generate time series data of the normalized cell diagnosis deviation for each battery cell by recursively repeating the following steps (i) to (iv) at least once:

(i) determining a first movement average and a second movement average for the time series data of the normalized cell diagnosis deviation of each battery cell [where the first movement average is a short-term movement average, and the second movement average is a long-term movement average], (ii) for each battery cell, determining a short- and long-term average difference corresponding to the difference between the first movement average and the second movement average, (iii) for each battery cell, determining a normalized value of the short- and long-term average difference as a normalized cell diagnosis deviation, and (iv) generating time series data of the normalized cell diagnosis deviation for each battery cell,

wherein the control circuit is configured to determine a statistical variable threshold that depends on a standard deviation of normalized cell diagnosis deviations of all battery cells,

wherein the control circuit is configured to generate time series data of the filter diagnosis value by filtering the time series data on the cell diagnosis deviation of each battery cell based on the statistical variable threshold, and

wherein the control circuit is configured to detect a voltage abnormality of the battery cell from the time at which the filter diagnosis value exceeds a diagnosis threshold or the number of data of the filter diagnosis value that exceeds the diagnosis threshold.

10. The battery diagnosing apparatus according to claim 1,

wherein a profile for the time series data of the cell voltage of each battery cell includes voltage data equal to or less than a preset diagnosis start voltage and includes an inflection point after a time point at which the voltage data is measured.

11. A battery pack, comprising the battery diagnosing apparatus according to any one of claims 1 to 10.

12. A vehicle, comprising the battery pack according to claim 11.

13. A battery diagnosing method for a cell group, which includes a plurality of battery cells connected in series and is mounted in an electric vehicle, the battery diagnosing method comprising:

(a) generating a voltage signal representing a cell voltage of each battery cell while the electric vehicle is operating (S310);

(b) accumulatively storing the cell voltage determined from the voltage signal in a memory unit;

(c) periodically generating time series data representing the change over time in the cell voltage of each battery cell;

(d) determining a first average cell voltage and a second average cell voltage of each battery cell based on the time series data (S320), where the first average cell voltage is a short-term movement average, and the second average cell voltage is a long-term movement average; and

(e) detecting a voltage abnormality of each battery cell based on the difference between the first average cell voltage and the second average cell voltage.

14. The battery diagnosing method according to claim 13,

wherein the step (e) includes:

(e1) for each battery cell, determining a short- and long-term average difference corresponding to the difference between the first average cell voltage and the second average cell voltage;

(e2) for each battery cell, determining a cell diagnosis deviation corresponding to a deviation between the short- and long-term average difference of the battery cell and an average value of short- and long-term average differences of all battery cells; and

(e3) detecting a battery cell satisfying a condition that the cell diagnosis deviation exceeds a diagnosis threshold as a voltage abnormal cell.

**15.** The battery diagnosing method according to claim 14,
wherein the step (e) includes:

(e1) for each battery cell, generating time series data of the cell diagnosis deviation; and
(e2) detecting a voltage abnormality of the battery cell from the time at which the cell diagnosis deviation exceeds the diagnosis threshold or the number of data of the cell diagnosis deviation exceeding the diagnosis threshold.

**16.** The battery diagnosing method according to claim 13,
wherein the step (e) includes:

(e1) for each battery cell, determining a short- and long-term average difference corresponding to the difference between the first average cell voltage and the second average cell voltage;
(e2) for each battery cell, determining a cell diagnosis deviation by calculating a deviation between the short- and long-term average difference of the battery cell and an average value of short- and long-term average differences of all battery cells;
(e3) determining a statistical variable threshold that depends on a standard deviation of the cell diagnosis deviations of all battery cells;
(e4) generating time series data of a filter diagnosis value for each battery cell by filtering the time series data on the cell diagnosis deviation of each battery cell based on the statistical variable threshold; and
(e5) detecting a voltage abnormality of the battery cell from the time at which the filter diagnosis value exceeds a diagnosis threshold or the number of data of the filter diagnosis value that exceeds the diagnosis threshold.

**17.** The battery diagnosing method according to claim 13,
wherein the (e) step includes:

(e1) for each battery cell, determining a short- and long-term average difference corresponding to the difference between the first average cell voltage and the second average cell voltage;
(e2) for each battery cell, determining a normalized value of the short- and long-term average difference as a normalized cell diagnosis deviation;
(e3) determining a statistical variable threshold that depends on a standard deviation for the normalized cell diagnosis deviations of all battery cells;
(e4) generating time series data of the filter diagnosis value by filtering the time series data on the normalized cell diagnosis deviation of each battery cell based on the statistical variable threshold; and
(e5) detecting a voltage abnormality of the battery cell from the time at which the filter diagnosis value exceeds a diagnosis threshold or the number of data of the filter diagnosis value that exceeds the diagnosis threshold.

**18.** The battery diagnosing method according to claim 17,
wherein the step (e2) is a step of normalizing the short- and long-term average difference for each battery cell by dividing the short- and long-term average difference by an average value of short- and long-term average differences of all battery cells.

**19.** The battery diagnosing method according to claim 17,
wherein the step (e2) is a step of normalizing the short- and long-term average difference for each battery cell by calculating the logarithm of the short- and long-term average difference.

**20.** The battery diagnosing method according to claim 13,
wherein the step (a) is a step of generating time series data representing the change over time in the cell voltage of each battery cell using a voltage difference between an average value of the cell voltages of all battery cells and the cell voltage of each battery cell measured per unit time.

**21.** The battery diagnosing method according to claim 13,
wherein the step (e) includes:

(e1) for each battery cell, determining a short- and long-term average difference corresponding to the difference between the first average cell voltage and the second average cell voltage;

(e2) for each battery cell, determining a normalized value of the short- and long-term average difference as a normalized cell diagnosis deviation;

(e3) generating time series data of the normalized cell diagnosis deviation for each battery cell;

(e4) generating time series data of the normalized cell diagnosis deviation for each battery cell by recursively repeating the following steps (i) to (iv) at least once:

(i) determining a first movement average and a second movement average for the time series data of the normalized cell diagnosis deviation of each battery cell [where the first movement average is a short-term movement average, and the second movement average is a long-term movement average], (ii) for each battery cell, determining a short- and long-term average difference corresponding to the difference between the first movement average and the second movement average, (iii) for each battery cell, determining a normalized value of the short- and long-term average difference as a normalized cell diagnosis deviation, and (iv) generating time series data of the normalized cell diagnosis deviation for each battery cell,

(e5) determining a statistical variable threshold that depends on a standard deviation of normalized cell diagnosis deviations of all battery cells;

(e6) generating time series data of the filter diagnosis value by filtering the time series data on the cell diagnosis deviation of each battery cell based on the statistical variable threshold; and

(e7) detecting a voltage abnormality of the battery cell from the time at which the filter diagnosis value exceeds a diagnosis threshold or the number of data of the filter diagnosis value that exceeds the diagnosis threshold.

22. The battery diagnosing method according to claim 13,
wherein a profile for the time series data of the cell voltage of each battery cell includes voltage data equal to or less than a preset diagnosis start voltage and includes an inflection point after a time point at which the voltage data is measured.

**Patentansprüche**

1. Batteriediagnosevorrichtung (200) für eine Zellengruppe (CG), welche eine Mehrzahl von Batteriezellen ($BC_1 ... BC_N$) umfasst, welche in Reihe geschaltet sind, und welche in einem Elektrofahrzeug (1) montiert ist, wobei die Batteriediagnosevorrichtung umfasst:

eine spannungsabtastende Schaltung (210), welche dazu eingerichtet ist, periodisch ein Spannungssignal zu erzeugen, welches eine Zellenspannung jeder Batteriezelle repräsentiert, während das Elektrofahrzeug in Betrieb ist; und

eine Steuerschaltung (220), welche dazu eingerichtet ist, die Zellenspannung, welche aus dem Spannungssignal bestimmt worden ist, in einer Speichereinheit akkumulierend zu speichern und Zeitseriendaten, welche die Änderung über die Zeit in der Zellenspannung jeder Batteriezelle repräsentieren, unter Verwendung der akkumulierten Zellenspannung jeder Batteriezelle zu erzeugen,

wobei die Steuerschaltung eingerichtet ist, zum:

(i) Bestimmen einer ersten durchschnittlichen Zellenspannung und einer zweiten durchschnittlichen Zellenspannung jeder Batteriezelle auf Grundlage der Zeitseriendaten, wobei die erste durchschnittliche Zellenspannung ein kurzzeitiger Entwicklungsdurchschnitt ist und die zweite durchschnittliche Zellenspannung ein langzeitiger Entwicklungsdurchschnitt ist, und

(ii) Detektieren einer Spannungsanomalie jeder Batteriezelle auf Grundlage der Differenz zwischen der ersten durchschnittlichen Zellenspannung und der zweiten durchschnittlichen Zellenspannung.

2. Batteriediagnosevorrichtung nach Anspruch 1,

wobei, für jede Batteriezelle, die Steuerschaltung dazu eingerichtet ist, eine kurzzeitige und langzeitige Durchschnittsdifferenz zu bestimmen, welche der Differenz zwischen der ersten durchschnittlichen Zellenspannung und der zweiten durchschnittlichen Zellenspannung entspricht,

wobei, für jede Batteriezelle, die Steuerschaltung dazu eingerichtet ist, eine Zellendiagnoseabweichung zu bestimmen, welche einer Abweichung zwischen der kurzzeitigen und langzeitigen Durchschnittsdifferenz der Batteriezelle und einem Durchschnittswert kurzzeitiger und langzeitiger Durchschnittsdifferenzen aller Batteriezellen entspricht, und

wobei die Steuerschaltung dazu eingerichtet ist, eine Batteriezelle, welche eine Bedingung erfüllt, dass die Zellendiagnoseabweichung einen Diagnoseschwellenwert übersteigt, als eine spannungsanomale Zelle zu detektieren.

3. Batteriediagnosevorrichtung nach Anspruch 2,
wobei, für jede Batteriezelle, die Steuerschaltung dazu eingerichtet ist, Zeitseriendaten der Zellendiagnoseabweichung zu erzeugen und eine Spannungsanomalie der Batteriezelle zu der Zeit, bei welcher die Zellendiagnoseabweichung den Diagnoseschwellenwert übersteigt, oder der Anzahl von Daten der Zellendiagnoseabweichung zu detektieren, welche den Diagnoseschwellenwert übersteigt.

4. Batteriediagnosevorrichtung nach Anspruch 1,

wobei, für jede Batteriezelle, die Steuerschaltung dazu eingerichtet ist, eine kurzzeitige und langzeitige Durchschnittsdifferenz zu bestimmen, welche der Differenz zwischen der ersten durchschnittlichen Zellenspannung und der zweiten durchschnittlichen Zellenspannung entspricht,
wobei, für jede Batteriezelle, die Steuerschaltung dazu eingerichtet ist, durch Berechnen einer Abweichung zwischen der kurzzeitigen und langzeitigen Durchschnittsdifferenz der Batteriezelle und einem Durchschnittswert kurzzeitiger und langzeitiger Durchschnittsdifferenzen aller Batteriezellen eine Zellendiagnoseabweichung zu bestimmen,
wobei die Steuerschaltung dazu eingerichtet ist, einen statistischen variablen Schwellenwert zu bestimmen, welcher von einer Standardabweichung der Zellendiagnoseabweichungen aller Batteriezellen abhängt,
wobei die Steuerschaltung dazu eingerichtet ist, Zeitseriendaten eines Filterdiagnosewertes durch Filtern der Zeitseriendaten an der Zellendiagnoseabweichung jeder Batteriezelle auf Grundlage des statistischen variablen Schwellenwertes zu erzeugen, und
wobei die Steuerschaltung dazu eingerichtet ist, eine Spannungsanomalie der Batteriezelle zu der Zeit, bei welcher der Filterdiagnosewert einen Diagnoseschwellenwert übersteigt, oder der Anzahl von Daten des Filterdiagnosewertes zu detektieren, welcher den Diagnoseschwellenwert übersteigt.

5. Batteriediagnosevorrichtung nach Anspruch 1,

wobei, für jede Batteriezelle, die Steuerschaltung dazu eingerichtet ist, eine kurzzeitige und langzeitige Durchschnittsdifferenz zu bestimmen, welche der Differenz zwischen der ersten durchschnittlichen Zellenspannung und der zweiten durchschnittlichen Zellenspannung entspricht,
wobei für jede Batteriezelle, die Steuerschaltung dazu eingerichtet ist, einen normalisierten Wert der kurzzeitigen und langzeitigen Durchschnittsdifferenz als eine normalisierte Zellendiagnoseabweichung zu bestimmen und einen statistischen variablen Schwellenwert zu bestimmen, welcher von einer Standardabweichung für die normalisierten Zellendiagnoseabweichungen aller Batteriezellen abhängt,
wobei die Steuerschaltung dazu eingerichtet ist, Zeitseriendaten des Filterdiagnosewertes durch Filtern der Zeitseriendaten an der normalisierten Zellendiagnoseabweichung jeder Batteriezelle auf Grundlage des statistischen variablen Schwellenwertes zu erzeugen, und
wobei die Steuerschaltung dazu eingerichtet ist, eine Spannungsanomalie der Batteriezelle zu der Zeit, bei welcher der Filterdiagnosewert einen Diagnoseschwellenwert übersteigt, oder der Anzahl von Daten des Filterdiagnosewertes zu detektieren, welcher den Diagnoseschwellenwert übersteigt.

6. Batteriediagnosevorrichtung nach Anspruch 5,
wobei die Steuerschaltung dazu eingerichtet ist, die kurzzeitige und langzeitige Durchschnittsdifferenz für jede Batteriezelle durch Dividieren der kurzzeitigen und langzeitigen Durchschnittsdifferenz durch einen Durchschnittswert der kurzzeitigen und langzeitigen Durchschnittsdifferenzen aller Batteriezellen zu normalisieren.

7. Batteriediagnosevorrichtung nach Anspruch 5,
wobei die Steuerschaltung dazu eingerichtet ist, die kurzzeitige und langzeitige Durchschnittsdifferenz für jede Batteriezelle durch Berechnen des Logarithmus der kurzzeitigen und langzeitigen Durchschnittsdifferenz zu normalisieren.

8. Batteriediagnosevorrichtung nach Anspruch 1,
wobei die Steuerschaltung dazu eingerichtet ist, Zeitseriendaten, welche die Änderung über die Zeit in der Zellenspannung jeder Batteriezelle repräsentieren, unter Verwendung einer Spannungsdifferenz zwischen einem Durchschnittswert der Zellenspannungen aller Batteriezellen und der Zellenspannung jeder Batteriezelle zu erzeugen, welche pro Einheitszeit gemessen wird.

9. Batteriediagnosevorrichtung nach Anspruch 1,

wobei, für jede Batteriezelle, die Steuerschaltung dazu eingerichtet ist, eine kurzzeitige und langzeitige Durchschnittsdifferenz zu bestimmen, welche der Differenz zwischen der ersten durchschnittlichen Zellenspannung und der zweiten durchschnittlichen Zellenspannung entspricht,
wobei für jede Batteriezelle, die Steuerschaltung dazu eingerichtet ist, einen normalisierten Wert der kurzzeitigen und langzeitigen Durchschnittsdifferenz als eine normalisierte Zellendiagnoseabweichung zu bestimmen und Zeitseriendaten der normalisierten Zellendiagnoseabweichung für jede Batteriezelle zu erzeugen,
wobei die Steuerschaltung dazu eingerichtet ist, Zeitseriendaten der normalisierten Zellendiagnoseabweichung für jede Batteriezelle zu erzeugen, durch rekursives Wiederholen der folgenden Schritte (i) bis (iv) wenigstens einmal:

(i) Bestimmen eines ersten Entwicklungsdurchschnitts und eines zweiten Entwicklungsdurchschnitts für die Zeitseriendaten der normalisierten Zellendiagnoseabweichung für jede Batteriezelle [, wenn der erste Entwicklungsdurchschnitt ein kurzzeitiger Entwicklungsdurchschnitt ist und der zweite Entwicklungsdurchschnitt ein langzeitiger Entwicklungsdurchschnitt ist], (ii) für jede Batteriezelle, Bestimmen einer kurzzeitigen und langzeitigen Durchschnittsdifferenz, welche der Differenz zwischen dem ersten Entwicklungsdurchschnitt und dem zweiten Entwicklungsdurchschnitt entspricht, (iii) für jede Batteriezelle, Bestimmen eines normalisierten Wertes der kurzzeitigen und langzeitigen Durchschnittsdifferenz als eine normalisierte Zellendiagnoseabweichung, und (iv) Erzeugen von Zeitseriendaten der normalisierten Zellendiagnoseabweichung für jede Batteriezelle,
wobei die Steuerschaltung dazu eingerichtet ist, einen statistischen variablen Schwellenwert zu bestimmen, welcher von einer Standardabweichung der normalisierten Zellendiagnoseabweichungen aller Batteriezellen abhängt,
wobei die Steuerschaltung dazu eingerichtet ist, Zeitseriendaten des Filterdiagnosewertes durch Filtern der Zeitseriendaten an der Zellendiagnoseabweichung jeder Batteriezelle auf Grundlage des statistischen variablen Schwellenwertes zu erzeugen, und
wobei die Steuerschaltung dazu eingerichtet ist, eine Spannungsanomalie der Batteriezelle zu der Zeit, bei welcher der Filterdiagnosewert einen Diagnoseschwellenwert übersteigt, oder der Anzahl von Daten des Filterdiagnosewertes zu detektieren, welcher den Diagnoseschwellenwert übersteigt.

10. Batteriediagnosevorrichtung nach Anspruch 1,
wobei ein Profil für die Zeitseriendaten der Zellenspannung jeder Batteriezelle Spannungsdaten umfasst, welche gleich wie oder geringer als eine vorfestgelegte Diagnose-Startspannung sind, und einen Wendepunkt nach einem Zeitpunkt umfasst, an welchem die Spannungsdaten gemessen werden.

11. Batteriepack, umfassend die Batteriediagnosevorrichtung nach einem der Ansprüche 1 bis 10.

12. Fahrzeug, umfassend den Batteriepack nach Anspruch 11.

13. Batteriediagnoseverfahren für eine Zellengruppe, welche eine Mehrzahl von Batteriezellen umfasst, welche in Reihe geschaltet sind, und welche in einem Elektrofahrzeug montiert ist, wobei das Batteriediagnoseverfahren umfasst:

(a) Erzeugen eines Spannungssignals, welches eine Zellenspannung jeder Batteriezelle repräsentiert, während das Elektrofahrzeug in Betrieb ist (S310);
(b) Akkumulierendes Speichern der Zellenspannung, welche aus dem Spannungssignal bestimmt wird, in einer Speichereinheit;
(c) Periodisches Erzeugen von Zeitseriendaten, welche die Änderung über die Zeit in der Zellenspannung jeder Batteriezelle repräsentieren;
(d) Bestimmen einer ersten durchschnittlichen Zellenspannung und einer zweiten durchschnittlichen Zellenspannung jeder Batteriezelle auf Grundlage der Zeitseriendaten (S320), wenn die erste durchschnittliche Zellenspannung ein kurzzeitiger Entwicklungsdurchschnitt ist und die zweite durchschnittliche Zellenspannung ein langzeitiger Entwicklungsdurchschnitt ist; und
(e) Detektieren einer Spannungsanomalie für jede Batteriezelle auf Grundlage der Differenz zwischen der ersten durchschnittlichen Zellenspannung und der zweiten durchschnittlichen Zellenspannung.

**14.** Batteriediagnoseverfahren nach Anspruch 13,
wobei der Schritt (e) umfasst:

(e1) für jede Batteriezelle, Bestimmen einer kurzzeitigen und langzeitigen Durchschnittsdifferenz, welche der Differenz zwischen der ersten durchschnittlichen Zellenspannung und der zweiten durchschnittlichen Zellenspannung entspricht;
(e2) für jede Batteriezelle, Bestimmen einer Zellendiagnoseabweichung, welche einer Abweichung zwischen der kurzzeitigen und langzeitigen Durchschnittsdifferenz der Batteriezelle und einem Durchschnittswert kurzzeitiger und langzeitiger Durchschnittsdifferenzen aller Batteriezellen entspricht; und
(e3) Detektieren einer Batteriezelle, welche eine Bedingung erfüllt, dass die Zellendiagnoseabweichung einen Diagnoseschwellenwert übersteigt, als eine spannungsanomale Zelle.

**15.** Batteriediagnoseverfahren nach Anspruch 14,
wobei der Schritt (e) umfasst:

(e1) für jede Batteriezelle, Erzeugen von Zeitseriendaten der Zellendiagnoseabweichung; und
(e2) Detektieren einer Spannungsanomalie der Batteriezelle zu der Zeit, bei welcher die Zellendiagnoseabweichung den Diagnoseschwellenwert übersteigt, oder der Anzahl von Daten der Zellendiagnoseabweichung, welche den Diagnoseschwellenwert übersteigt.

**16.** Batteriediagnoseverfahren nach Anspruch 13,
wobei der Schritt (e) umfasst:

(e1) für jede Batteriezelle, Bestimmen einer kurzzeitigen und langzeitigen Durchschnittsdifferenz, welche der Differenz zwischen der ersten durchschnittlichen Zellenspannung und der zweiten durchschnittlichen Zellenspannung entspricht;
(e2) für jede Batteriezelle, Bestimmen einer Zellendiagnoseabweichung durch Berechnen einer Abweichung zwischen der kurzzeitigen und langzeitigen Durchschnittsdifferenz der Batteriezelle und einem Durchschnittswert kurzzeitiger und langzeitiger Durchschnittsdifferenzen aller Batteriezellen;
(e3) Bestimmen eines statistischen variablen Schwellenwertes, welcher von einer Standardabweichung der Zellendiagnoseabweichungen aller Batteriezellen abhängt;
(e4) Erzeugen von Zeitseriendaten eines Filterdiagnosewertes für jede Batteriezelle durch Filtern der Zeitseriendaten an der Zellendiagnoseabweichung jeder Batteriezelle auf Grundlage des statistischen variablen Schwellenwertes; und
(e5) Detektieren einer Spannungsanomalie der Batteriezelle zu der Zeit, bei welcher der Filterdiagnosewert einen Diagnoseschwellenwert übersteigt, oder der Anzahl von Daten des Filterdiagnosewertes, welcher den Diagnoseschwellenwert übersteigt.

**17.** Batteriediagnoseverfahren nach Anspruch 13,
wobei der (e)-Schritt umfasst:

(e1) für jede Batteriezelle, Bestimmen einer kurzzeitigen und langzeitigen Durchschnittsdifferenz, welche der Differenz zwischen der ersten durchschnittlichen Zellenspannung und der zweiten durchschnittlichen Zellenspannung entspricht;
(e2) für jede Batteriezelle, Bestimmen eines normalisierten Wertes der kurzzeitigen und langzeitigen Durchschnittsdifferenz als eine normalisierte Zellendiagnoseabweichung;
(e3) Bestimmen eines statistischen variablen Schwellenwertes, welcher von einer Standardabweichung der normalisierten Zellendiagnoseabweichungen aller Batteriezellen abhängt;
(e4) Erzeugen von Zeitseriendaten des Filterdiagnosewertes durch Filtern der Zeitseriendaten an der normalisierten Zellendiagnoseabweichung jeder Batteriezelle auf Grundlage des statistischen variablen Schwellenwertes; und
(e5) Detektieren einer Spannungsanomalie der Batteriezelle zu der Zeit, bei welcher der Filterdiagnosewert einen Diagnoseschwellenwert übersteigt, oder der Anzahl von Daten des Filterdiagnosewertes, welche den Diagnoseschwellenwert übersteigt.

**18.** Batteriediagnoseverfahren nach Anspruch 17,
wobei der Schritt (e2) ein Schritt eines Normalisierens der kurzzeitigen und langzeitigen Durchschnittsdifferenz für jede Batteriezelle durch Dividieren der kurzzeitigen und langzeitigen Durchschnittsdifferenz durch einen Durchschnittswert von kurzzeitigen und langzeitigen Durchschnittsdifferenzen aller Batteriezellen ist.

19. Batteriediagnoseverfahren nach Anspruch 17,
    wobei der Schritt (e2) ein Schritt eines Normalisierens der kurzzeitigen und langzeitigen Durchschnittsdifferenz für jede Batteriezelle durch Berechnen des Logarithmus der kurzzeitigen und langzeitigen Durchschnittsdifferenz ist.

20. Batteriediagnoseverfahren nach Anspruch 13,
    wobei der Schritt (a) ein Schritt eines Erzeugens von Zeitseriendaten, welche die Änderung über die Zeit in der Zellenspannung jeder Batteriezelle repräsentieren, unter Verwendung einer Spannungsdifferenz zwischen einem Durchschnittswert der Zellenspannungen aller Batteriezellen und der Zellenspannung jeder Batteriezelle ist, welche pro Einheitszeit gemessen wird.

21. Batteriediagnoseverfahren nach Anspruch 13,
    wobei der Schritt (e) umfasst:

    (e1) für jede Batteriezelle, Bestimmen einer kurzzeitigen und langzeitigen Durchschnittsdifferenz, welche der Differenz zwischen der ersten durchschnittlichen Zellenspannung und der zweiten durchschnittlichen Zellenspannung entspricht;
    (e2) für jede Batteriezelle, Bestimmen eines normalisierten Wertes der kurzzeitigen und langzeitigen Durchschnittsdifferenz als eine normalisierte Zellendiagnoseabweichung;
    (e3) Erzeugen von Zeitseriendaten der normalisierten Zellendiagnoseabweichung für jede Batteriezelle;
    (e4) Erzeugen von Zeitseriendaten der normalisierten Zellendiagnoseabweichung für jede Batteriezelle durch rekursives Wiederholen der folgenden Schritte (i) bis (iv) wenigstens einmal:

    (i) Bestimmen eines ersten Entwicklungsdurchschnitts und eines zweiten Entwicklungsdurchschnitts für die Zeitseriendaten der normalisierten Zellendiagnoseabweichung für jede Batteriezelle [, wenn der erste Entwicklungsdurchschnitt ein kurzzeitiger Entwicklungsdurchschnitt ist und der zweite Entwicklungsdurchschnitt ein langzeitiger Entwicklungsdurchschnitt ist], (ii) für jede Batteriezelle, Bestimmen einer kurzzeitigen und langzeitigen Durchschnittsdifferenz, welche der Differenz zwischen dem ersten Entwicklungsdurchschnitt und dem zweiten Entwicklungsdurchschnitt entspricht, (iii) für jede Batteriezelle, Bestimmen eines normalisierten Wertes der kurzzeitigen und langzeitigen Durchschnittsdifferenz als eine normalisierte Zellendiagnoseabweichung, und (iv) Erzeugen von Zeitseriendaten der normalisierten Zellendiagnoseabweichung für jede Batteriezelle,
    (e5) Bestimmen eines statistisch variablen Schwellenwertes, welcher von einer Standardabweichung normalisierter Zellendiagnoseabweichungen aller Batteriezellen abhängt;
    (e6) Erzeugen von Zeitseriendaten eines Filterdiagnosewertes durch Filtern der Zeitseriendaten an der Zellendiagnoseabweichung jeder Batteriezelle auf Grundlage des statistischen variablen Schwellenwertes; und
    (e7) Detektieren einer Spannungsanomalie der Batteriezelle zu der Zeit, bei welcher der Filterdiagnosewert einen Diagnoseschwellenwert übersteigt, oder der Anzahl von Daten des Filterdiagnosewertes, welcher den Diagnoseschwellenwert übersteigt.

22. Batteriediagnoseverfahren nach Anspruch 13,
    wobei ein Profil für die Zeitseriendaten der Zellenspannung jeder Batteriezelle Spannungsdaten umfasst, welche gleich wie oder geringer als eine vorfestgelegte Diagnose-Startspannung sind, und einen Wendepunkt nach einem Zeitpunkt umfasst, an welchem die Spannungsdaten gemessen werden.

**Revendications**

1. Appareil de diagnostic de batterie (200) pour un groupe de cellules (CG), qui inclut une pluralité de cellules de batterie ($BC_1$ ... $BC_N$) connectées en série et montées dans un véhicule électrique (1), l'appareil de diagnostic de batterie comprenant :

    un circuit de détection de tension (210) configuré pour générer périodiquement un signal de tension représentant une tension de cellule de chaque cellule de batterie pendant que le véhicule électrique fonctionne ; et
    un circuit de commande (220) configuré pour stocker de manière cumulative la tension de cellule déterminée à partir du signal de tension dans une unité de mémoire et générer des données de série temporelle représentant le changement dans le temps de la tension de cellule de chaque cellule de batterie en utilisant la tension de cellule accumulée de chaque cellule de batterie,
dans lequel le circuit de commande est configuré pour :

(i) déterminer une première tension de cellule moyenne et une seconde tension de cellule moyenne de chaque cellule de batterie sur la base des données de série temporelle, où
la première tension de cellule moyenne est une moyenne de mouvement à court terme, et la seconde tension de cellule moyenne est une moyenne de mouvement à long terme, et
(ii) détecter une anomalie de tension de chaque cellule de batterie sur la base de la différence entre la première tension de cellule moyenne et la seconde tension de cellule moyenne.

2. Appareil de diagnostic de batterie selon la revendication 1,

dans lequel, pour chaque cellule de batterie, le circuit de commande est configuré pour déterminer une différence moyenne à court et à long terme correspondant à la différence entre la première tension de cellule moyenne et la seconde tension de cellule moyenne,
dans lequel, pour chaque cellule de batterie, le circuit de commande est configuré pour déterminer un écart de diagnostic de cellule correspondant à un écart entre la différence moyenne à court et à long terme de la cellule de batterie et une valeur moyenne de différences moyennes à court et à long terme de toutes les cellules de batterie, et
dans lequel le circuit de commande est configuré pour détecter une cellule de batterie satisfaisant à une condition selon laquelle l'écart de diagnostic de cellule dépasse un seuil de diagnostic en tant que cellule à tension anormale.

3. Appareil de diagnostic de batterie selon la revendication 2,
dans lequel, pour chaque cellule de batterie, le circuit de commande est configuré pour générer des données de série temporelle de l'écart de diagnostic de cellule et détecter une anomalie de tension de la cellule de batterie à partir du moment où l'écart de diagnostic de cellule dépasse le seuil de diagnostic ou du nombre de données de l'écart de diagnostic de cellule dépassant le seuil de diagnostic.

4. Appareil de diagnostic de batterie selon la revendication 1,

dans lequel, pour chaque cellule de batterie, le circuit de commande est configuré pour déterminer une différence moyenne à court et à long terme correspondant à la différence entre la première tension de cellule moyenne et la seconde tension de cellule moyenne,
dans lequel, pour chaque cellule de batterie, le circuit de commande est configuré pour déterminer un écart de diagnostic de cellule en calculant un écart entre la différence moyenne à court et à long terme de la cellule de batterie et une valeur moyenne de différences moyennes à court et à long terme de toutes les cellules de batterie,
dans lequel le circuit de commande est configuré pour déterminer un seuil de variable statistique qui dépend d'un écart type des écarts de diagnostic de cellule de toutes les cellules de batterie,
dans lequel le circuit de commande est configuré pour générer des données de série temporelle d'une valeur de diagnostic de filtre en filtrant les données de série temporelle sur l'écart de diagnostic de cellule de chaque cellule de batterie sur la base du seuil de variable statistique, et
dans lequel le circuit de commande est configuré pour détecter une anomalie de tension de la cellule de batterie à partir du moment où la valeur de diagnostic de filtre dépasse un seuil de diagnostic ou du nombre de données de la valeur de diagnostic de filtre dépassant le seuil de diagnostic.

5. Appareil de diagnostic de batterie selon la revendication 1,

dans lequel, pour chaque cellule de batterie, le circuit de commande est configuré pour déterminer une différence moyenne à court et à long terme correspondant à la différence entre la première tension de cellule moyenne et la seconde tension de cellule moyenne,
dans lequel, pour chaque cellule de batterie, le circuit de commande est configuré pour déterminer une valeur normalisée de la différence moyenne à court et à long terme en tant qu'écart de diagnostic de cellule normalisé et déterminer un seuil de variable statistique qui dépend d'un écart type pour les écarts de diagnostic de cellule normalisés de toutes les cellules de batterie,
dans lequel le circuit de commande est configuré pour générer des données de série temporelle de la valeur de diagnostic de filtre en filtrant les données de série temporelle sur l'écart de diagnostic de cellule normalisé de chaque cellule de batterie sur la base du seuil de variable statistique, et

dans lequel le circuit de commande est configuré pour détecter une anomalie de tension de la cellule de batterie à partir du moment où la valeur de diagnostic de filtre dépasse un seuil de diagnostic ou du nombre de données de la valeur de diagnostic de filtre dépassant le seuil de diagnostic.

6. Appareil de diagnostic de batterie selon la revendication 5,
dans lequel le circuit de commande est configuré pour normaliser la différence moyenne à court et à long terme pour chaque cellule de batterie en divisant la différence moyenne à court et à long terme par une valeur moyenne de différences moyennes à court et à long terme de toutes les cellules de batterie.

7. Appareil de diagnostic de batterie selon la revendication 5,
dans lequel le circuit de commande est configuré pour normaliser la différence moyenne à court et à long terme pour chaque cellule de batterie en calculant le logarithme de la différence moyenne à court et à long terme.

8. Appareil de diagnostic de batterie selon la revendication 1,
dans lequel le circuit de commande est configuré pour générer des données de série temporelle représentant le changement dans le temps de la tension de cellule de chaque cellule de batterie en utilisant une différence de tension entre une valeur moyenne des tensions de cellule de toutes les cellules de batterie et la tension de cellule de chaque cellule de batterie mesurée par unité de temps.

9. Appareil de diagnostic de batterie selon la revendication 1,

dans lequel, pour chaque cellule de batterie, le circuit de commande est configuré pour déterminer une différence moyenne à court et à long terme correspondant à la différence entre la première tension de cellule moyenne et la seconde tension de cellule moyenne,
dans lequel, pour chaque cellule de batterie, le circuit de commande est configuré pour déterminer une valeur normalisée de la différence moyenne à court et à long terme en tant qu'écart de diagnostic de cellule normalisé et générer des données de série temporelle de l'écart de diagnostic de cellule normalisé pour chaque cellule de batterie, dans lequel le circuit de commande est configuré pour générer des données de série temporelle de l'écart de diagnostic de cellule normalisé pour chaque cellule de batterie en répétant de manière récursive les étapes (i) à (iv) suivantes au moins une fois :

(i) la détermination d'une première moyenne de mouvement et d'une seconde moyenne de mouvement pour les données de série temporelle de l'écart de diagnostic de cellule normalisé de chaque cellule de batterie [où la première moyenne de mouvement est une moyenne de mouvement à court terme, et la seconde moyenne de mouvement est une moyenne de mouvement à long terme], (ii) pour chaque cellule de batterie, la détermination d'une différence moyenne à court et à long terme correspondant à la différence entre la première moyenne de mouvement et la seconde moyenne de mouvement, (iii) pour chaque cellule de batterie, la détermination d'une valeur normalisée de la différence moyenne à court et à long terme en tant qu'écart de diagnostic de cellule normalisé, et (iv) la génération de données de série temporelle de l'écart de diagnostic de cellule normalisé pour chaque cellule de batterie,
dans lequel le circuit de commande est configuré pour déterminer un seuil de variable statistique qui dépend d'un écart type d'écarts de diagnostic de cellule normalisés de toutes les cellules de batterie,
dans lequel le circuit de commande est configuré pour générer des données de série temporelle de la valeur de diagnostic de filtre en filtrant les données de série temporelle sur l'écart de diagnostic de cellule de chaque cellule de batterie sur la base du seuil de variable statistique, et
dans lequel le circuit de commande est configuré pour détecter une anomalie de tension de la cellule de batterie à partir du moment où la valeur de diagnostic de filtre dépasse un seuil de diagnostic ou du nombre de données de la valeur de diagnostic de filtre dépassant le seuil de diagnostic.

10. Appareil de diagnostic de batterie selon la revendication 1,
dans lequel un profil pour les données de série temporelle de la tension de cellule de chaque cellule de batterie inclut des données de tension égales ou inférieures à une tension de démarrage de diagnostic prédéfinie et inclut un point d'inflexion après un point temporel auquel les données de tension sont mesurées.

11. Bloc-batterie comprenant l'appareil de diagnostic de batterie selon l'une quelconque des revendications 1 à 10.

12. Véhicule, comprenant le bloc-batterie selon la revendication 11.

**13.** Procédé de diagnostic de batterie pour un groupe de cellules, qui inclut une pluralité de cellules de batterie connectées en série et montées dans un véhicule électrique, le procédé de diagnostic de batterie comprenant :

(a) la génération d'un signal de tension représentant une tension de cellule de chaque cellule de batterie pendant que le véhicule électrique fonctionne (S310) ;

(b) le stockage, de manière cumulative, de la tension de cellule déterminée à partir du signal de tension dans une unité de mémoire ;

(c) la génération périodique de données de série temporelle représentant le changement dans le temps dans la tension de cellule de chaque cellule de batterie ;

(d) la détermination d'une première tension de cellule moyenne et d'une seconde tension de cellule moyenne de chaque cellule de batterie sur la base des données de série temporelle (S320), où la première tension de cellule moyenne est une moyenne de mouvement à court terme, et la seconde tension de cellule moyenne est une moyenne de mouvement à long terme ; et

(e) la détection d'une anomalie de tension de chaque cellule de batterie sur la base de la différence entre la première tension de cellule moyenne et la seconde tension de cellule moyenne.

**14.** Procédé de diagnostic de batterie selon la revendication 13, dans lequel l'étape (e) comporte :

(e1) pour chaque cellule de batterie, la détermination d'une différence moyenne à court et à long terme correspondant à la différence entre la première tension de cellule moyenne et la seconde tension de cellule moyenne ;

(e2) pour chaque cellule de batterie, la détermination d'un écart de diagnostic de cellule correspondant à un écart entre la différence moyenne à court et à long terme de la cellule de batterie et une valeur moyenne de différences moyennes à court et à long terme de toutes les cellules de batterie, et

(e3) la détection d'une cellule de batterie satisfaisant à une condition selon laquelle l'écart de diagnostic de cellule dépasse un seuil de diagnostic en tant que cellule à tension anormale.

**15.** Procédé de diagnostic de batterie selon la revendication 14, dans lequel l'étape (e) comporte :

(e1) pour chaque cellule de batterie, la génération de données de série temporelle de l'écart de diagnostic de cellule ; et

(e2) la détection d'une anomalie de tension de la cellule de batterie à partir du moment où l'écart de diagnostic de cellule dépasse le seuil de diagnostic ou du nombre de données de l'écart de diagnostic de cellule dépassant le seuil de diagnostic.

**16.** Procédé de diagnostic de batterie selon la revendication 13, dans lequel l'étape (e) comporte :

(e1) pour chaque cellule de batterie, la détermination d'une différence moyenne à court et à long terme correspondant à la différence entre la première tension de cellule moyenne et la seconde tension de cellule moyenne ;

(e2) pour chaque cellule de batterie, la détermination d'un écart de diagnostic de cellule en calculant un écart entre la différence moyenne à court et à long terme de la cellule de batterie et une valeur moyenne de différences moyennes à court et à long terme de toutes les cellules de batterie, et

(e3) la détermination d'un seuil de variable statistique qui dépend d'un écart type des écarts de diagnostic de cellule de toutes les cellules de batterie ;

(e4) la génération de données de série temporelle d'une valeur de diagnostic de filtre pour chaque cellule de batterie en filtrant les données de série temporelle sur l'écart de diagnostic de cellule de chaque cellule de batterie sur la base du seuil de variable statistique ; et

(e5) la détection d'une anomalie de tension de la cellule de batterie à partir du moment où la valeur de diagnostic de filtre dépasse un seuil de diagnostic ou du nombre de données de la valeur de diagnostic de filtre dépassant le seuil de diagnostic.

**17.** Procédé de diagnostic de batterie selon la revendication 13, dans lequel l'étape (e) comporte :

(e1) pour chaque cellule de batterie, la détermination d'une différence moyenne à court et à long terme correspondant à la différence entre la première tension de cellule moyenne et la seconde tension de cellule moyenne ;

(e2) pour chaque cellule de batterie, la détermination d'une valeur normalisée de la différence moyenne à court et à long terme en tant qu'écart de diagnostic de cellule normalisé ;

(e3) la détermination d'un seuil de variable statistique qui dépend d'un écart type pour les écarts de diagnostic de cellule normalisés de toutes les cellules de batterie ;

(e4) la génération de données de série temporelle de la valeur de diagnostic de filtre en filtrant les données de série temporelle sur l'écart de diagnostic de cellule normalisé de chaque cellule de batterie sur la base du seuil de variable statistique ; et

(e5) la détection d'une anomalie de tension de la cellule de batterie à partir du moment où la valeur de diagnostic de filtre dépasse un seuil de diagnostic ou du nombre de données de la valeur de diagnostic de filtre dépassant le seuil de diagnostic.

18. Procédé de diagnostic de batterie selon la revendication 17,
dans lequel l'étape (e2) est une étape de normalisation de la différence moyenne à court et à long terme pour chaque cellule de batterie en divisant la différence moyenne à court et à long terme par une valeur moyenne de différences moyennes à court et à long terme de toutes les cellules de batterie.

19. Procédé de diagnostic de batterie selon la revendication 17,
dans lequel l'étape (e2) est une étape de normalisation de la différence moyenne à court et à long terme pour chaque cellule de batterie en calculant le logarithme de la différence moyenne à court et à long terme.

20. Procédé de diagnostic de batterie selon la revendication 13,
dans lequel l'étape (a) est une étape de génération de données de série temporelle représentant le changement dans le temps de la tension de cellule de chaque cellule de batterie en utilisant une différence de tension entre une valeur moyenne des tensions de cellule de toutes les cellules de batterie et la tension de cellule de chaque cellule de batterie mesurée par unité de temps.

21. Procédé de diagnostic de batterie selon la revendication 13,
dans lequel l'étape (e) comporte :

(e1) pour chaque cellule de batterie, la détermination d'une différence moyenne à court et à long terme correspondant à la différence entre la première tension de cellule moyenne et la seconde tension de cellule moyenne ;

(e2) pour chaque cellule de batterie, la détermination d'une valeur normalisée de la différence moyenne à court et à long terme en tant qu'écart de diagnostic de cellule normalisé ;

(e3) la génération de données de série temporelle de l'écart de diagnostic de cellule normalisé pour chaque cellule de batterie ;

(e4) la génération de données de série temporelle de l'écart de diagnostic de cellule normalisé pour chaque cellule de batterie en répétant de manière récursive les étapes (i) à (iv) suivantes au moins une fois :

(i) la détermination d'une première moyenne de mouvement et d'une seconde moyenne de mouvement pour les données de série temporelle de l'écart de diagnostic de cellule normalisé de chaque cellule de batterie [où la première moyenne de mouvement est une moyenne de mouvement à court terme, et la seconde moyenne de mouvement est une moyenne de mouvement à long terme], (ii) pour chaque cellule de batterie, la détermination d'une différence moyenne à court et à long terme correspondant à la différence entre la première moyenne de mouvement et la seconde moyenne de mouvement, (iii) pour chaque cellule de batterie, la détermination d'une valeur normalisée de la différence moyenne à court et à long terme en tant qu'écart de diagnostic de cellule normalisé, et (iv) la génération de données de série temporelle de l'écart de diagnostic de cellule normalisé pour chaque cellule de batterie,

(e5) la détermination d'un seuil de variable statistique qui dépend d'un écart type pour des écarts de diagnostic de cellule normalisés de toutes les cellules de batterie ;

(e6) la génération de données de série temporelle de la valeur de diagnostic de filtre en filtrant les données de série temporelle sur l'écart de diagnostic de cellule de chaque cellule de batterie sur la base du seuil de variable statistique ; et

(e7) la détection d'une anomalie de tension de la cellule de batterie à partir du moment où la valeur de diagnostic de filtre dépasse un seuil de diagnostic ou du nombre de données de la valeur de diagnostic de filtre dépassant le seuil de diagnostic.

22. Procédé de diagnostic de batterie selon la revendication 13, dans lequel un profil pour les données de série temporelle de la tension de cellule de chaque cellule de batterie inclut des données de tension égales ou inférieures à une tension de démarrage de diagnostic prédéfinie et inclut un point d'inflexion après un point temporel auquel les données de tension sont mesurées.

FIG. 1

FIG. 2a

FIG. 2b

FIG. 2c

FIG. 2d

FIG. 2e

FIG. 2f

FIG. 2g

FIG. 2h

FIG. 3

```
                    ┌─────────┐
                    │  START  │
                    └────┬────┘
                         │
                         ▼
┌──────────────────────────────────────────────────┐
│  GENERATE TIME SERIES DATA OF CELL VOLTAGE OF     │～ S310
│            EACH OF PLURAL CELLS                    │
└───────────────────────┬──────────────────────────┘
                        │
                        ▼
┌──────────────────────────────────────────────────┐
│  DETERMINE FIRST AVERAGE CELL VOLTAGE (SMA_i[k]) AND │～ S320
│      SECOND AVERAGE CELL VOLTAGE (LMA_i[k]) OF    │
│              EACH BATTERY CELL (BC_i)             │
└───────────────────────┬──────────────────────────┘
                        │
                        ▼
┌──────────────────────────────────────────────────┐
│    DETERMINE SHORT- AND LONG-TERM DIFFERENCE OF   │～ S330
│           EACH BATTERY CELL (BC_i)                │
└───────────────────────┬──────────────────────────┘
                        │
                        ▼
┌──────────────────────────────────────────────────┐
│  DETERMINE CELL DIAGNOSIS DEVIATION (D_diag,i[k]) OF │～ S340
│           EACH BATTERY CELL (BC_i)                │
└───────────────────────┬──────────────────────────┘
                        │
                        ▼
                  ╱─────────────╲         S350
                 ╱  HAS DIAGNOSIS ╲
                ╱  TIME HAVE ELAPSED? ╲──── NO
                ╲                  ╱
                 ╲────────┬───────╱
                      YES │
                          ▼
┌──────────────────────────────────────────────────┐
│  GENERATE TIME SERIES DATA FOR CELL DIAGNOSIS DEVIATION │ S360
│      (D_diag,i[k]) OF EACH BATTERY CELL (BC_i)    │
└───────────────────────┬──────────────────────────┘
                        │
                        ▼
┌──────────────────────────────────────────────────┐
│  DIAGNOSE VOLTAGE ABNORMALITY OF EACH BATTERY CELL (BC_i) │～ S370
└───────────────────────┬──────────────────────────┘
                        │
                        ▼
                   ┌─────────┐
                   │   END   │
                   └─────────┘
```

FIG. 4

START

GENERATE TIME SERIES DATA OF CELL VOLTAGE OF EACH OF PLURAL CELLS — S310

DETERMINE FIRST AVERAGE CELL VOLTAGE ($SMA_i[k]$) AND SECOND AVERAGE CELL VOLTAGE ($LMA_i[k]$) OF EACH BATTERY CELL ($BC_i$) — S320

DETERMINE SHORT- AND LONG-TERM DIFFERENCE OF EACH BATTERY CELL ($BC_i$) — S330

DETERMINE CELL DIAGNOSIS DEVIATION ($D_{diag,i}[k]$) OF EACH BATTERY CELL ($BC_i$) — S340

HAS DIAGNOSIS TIME ELAPSED? — S350

NO

YES

GENERATE TIME SERIES DATA FOR CELL DIAGNOSIS DEVIATION ($D_{diag,i}[k]$) OF EACH BATTERY CELL ($BC_i$) — S360

GENERATE TIME SERIES DATA OF STATISTICAL VARIABLE THRESHOLD ($D_{threshold}[k]$) — S380

GENERATE TIME SERIES DATA FOR FILTER DIAGNOSIS VALUE ($D_{filter,i}[k]$) OF EACH BATTERY CELL ($BC_i$) — S390

DIAGNOSE VOLTAGE ABNORMALITY OF EACH BATTERY CELL ($BC_i$) — S400

END

FIG. 5

START

↓

GENERATE TIME SERIES DATA OF CELL VOLTAGE OF EACH OF PLURAL CELLS ～ S310

↓

DETERMINE FIRST AVERAGE CELL VOLTAGE (SMA$_i$[k]) AND SECOND AVERAGE CELL VOLTAGE (LMA$_i$[k]) OF EACH BATTERY CELL (BC$_i$) ～ S320

↓

DETERMINE SHORT- AND LONG-TERM DIFFERENCE OF EACH BATTERY CELL (BC$_i$) ～ S330

↓

DETERMINE CELL DIAGNOSIS DEVIATION (D*$_{diag,i}$[k]) OF EACH BATTERY CELL (BC$_i$) ～ S340'

↓

HAS DIAGNOSIS TIME ELAPSED? ～ S350

NO

YES ↓

GENERATE TIME SERIES DATA FOR CELL DIAGNOSIS DEVIATION (D*$_{diag,i}$[k]) OF EACH BATTERY CELL (BC$_i$) S360'

↓

DIAGNOSE VOLTAGE ABNORMALITY OF EACH BATTERY CELL (BC$_i$) ～ S370'

↓

END

FIG. 6

```
                    ┌──────────┐
                    │  START   │
                    └──────────┘
                         │
   ┌─────────────────────────────────────────────┐
   │ GENERATE TIME SERIES DATA OF CELL VOLTAGE OF │ ～ S310
   │           EACH OF PLURAL CELLS               │
   └─────────────────────────────────────────────┘
                         │
   ┌─────────────────────────────────────────────┐
   │ DETERMINE FIRST AVERAGE CELL VOLTAGE (SMA_i[k])│ ～ S320
   │ AND SECOND AVERAGE CELL VOLTAGE (LMA_i[k]) OF │
   │         EACH BATTERY CELL (BC_i)             │
   └─────────────────────────────────────────────┘
                         │
   ┌─────────────────────────────────────────────┐
   │      DETERMINE SHORT- AND LONG-TERM           │ ～ S330
   │    DIFFERENCE OF EACH BATTERY CELL (BC_i)     │
   └─────────────────────────────────────────────┘
                         │
   ┌─────────────────────────────────────────────┐
   │      DETERMINE CELL DIAGNOSIS DEVIATION       │ ～ S340'
   │  (D*_{diag,i}[k]) OF EACH BATTERY CELL (BC_i) │
   └─────────────────────────────────────────────┘
                         │
                  ╱───────────────╲
                 ╱  HAS DIAGNOSIS   ╲ ～ S350
                 ╲  TIME ELAPSED?   ╱ ── NO
                  ╲───────────────╱
                         │ YES
   ┌─────────────────────────────────────────────┐
   │ GENERATE TIME SERIES DATA FOR CELL DIAGNOSIS  │ ～ S360'
   │ DEVIATION (D*_{diag,i}[k]) OF EACH BATTERY CELL (BC_i)│
   └─────────────────────────────────────────────┘
                         │
   ┌─────────────────────────────────────────────┐
   │   GENERATE TIME SERIES DATA OF STATISTICAL    │ ～ S380'
   │   VARIABLE THRESHOLD (D_{threshold}[k])       │
   └─────────────────────────────────────────────┘
                         │
   ┌─────────────────────────────────────────────┐
   │        GENERATE TIME SERIES DATA FOR          │ ～ S390'
   │    FILTER DIAGNOSIS VALUE (D_{filter,i}[k]) OF │
   │         EACH BATTERY CELL (BC_i)             │
   └─────────────────────────────────────────────┘
                         │
   ┌─────────────────────────────────────────────┐
   │      DIAGNOSE VOLTAGE ABNORMALITY OF          │ ～ S400'
   │         EACH BATTERY CELL (BC_i)             │
   └─────────────────────────────────────────────┘
                         │
                    ┌──────────┐
                    │   END    │
                    └──────────┘
```

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220061076

- JP 2007085916 A